# EUROPEAN PATENT APPLICATION

(11) **EP 4 131 781 A1**
(43) Date of publication of application: **08.02.2023**
(21) Application number: 21787987.3
(22) Date of filing: 13.04.2021
(51) Int. Cl.: H03K 17/693, H04B 1/44

(54) **SWITCH AND ELECTRONIC DEVICE INCLUDING SWITCH**

(30) Priority: 13.04.2020 KR 20200044761
(71) Applicant: Samsung Electronics Co., Ltd., Gyeonggi-do 16677 (KR)
(72) Inventor: YOO, Jonghun, Suwon-si Gyeonggi-do 16677 (KR); YANG, Dongil, Suwon-si Gyeonggi-do 16677 (KR); KIM, Taeyoung, Suwon-si Gyeonggi-do 16677 (KR); NA, Hyoseok, Suwon-si Gyeonggi-do 16677 (KR); AN, Yongjun, Suwon-si Gyeonggi-do 16677 (KR)
(74) Representative: Gulde & Partner
(86) International application number: PCT/KR2021/004645
(87) International publication number: WO 2021/210890

(57) **Abstract**

Various embodiments related to an electronic device have been described. According to an embodiment, a switch may comprise a first terminal for receiving an RF input signal; a second terminal electrically connectable to the first terminal; a third terminal electrically connectable to the first terminal; a fourth terminal electrically connectable to the second terminal; and a circuit for, on the basis of a first control signal, electrically connecting the first terminal and the second terminal so as to form a first path through which the RF input is transmitted, and for, on the basis of a second control signal, connecting the first terminal and the third terminal, and connecting the second terminal and the fourth terminal, so as to form a second path through which the RF input signal is transmitted. Other embodiments may also be possible.

## Description

### [Technical Field]

Various embodiments generally relate to a switch and an electronic device including a switch.

### [Background Art]

A switch is a device for changing the opening/closing or connection state of an electric circuit and can be used for various purposes in various electronic devices. For example, the switch may be used to continue or block the flow of current or voltage, or to continue or block the flow of various signals.

For example, the switch may be implemented in various types according to the number of options, such as single pole single throw (SPST), single pole double throw (SPDT), or double pole double throw (DPDT).

### [Detailed Description of the Invention]

### [Technical Problem]

In a miniaturized electronic device or a foldable electronic device, it may be difficult to secure a communication environment in different frequency bands. For example, it is increasingly common to selectively use a first path to pass (bypass) a signal (e.g., an RF signal) and a second path to pass the signal through an external element (e.g., a filter, attenuator, amplifier, or other external element) in an operating environment independent between antennas of each other (e.g. in sufficient electronic device.

According to various embodiments, there may be provided a switch capable of switching between a first path to pass (bypass) a signal from a first node (e.g., an RF signal) to reach a second node between the first node and the second node and a second path that allows the signal from the first node to reach the second node via an external element (e.g., a filter, attenuator, amplifier or other external element).

### [Technical Solution]

According to various embodiments, a switch may include a first terminal for receiving an RF input signal, a second terminal electrically connectable to the first terminal, a third terminal electrically connectable to the first terminal, a fourth terminal electrically connectable to the second terminal, and a circuit for electrically connecting the first terminal and the second terminal, based on a first control signal to form a first path through which the RF input is transmitted, and for connecting the first terminal and the third terminal and connecting the second terminal and the fourth terminal, based on a second control signal to form a second path through which the RF input signal is transmitted.

According to various embodiments, a switch may include a first terminal for receiving an RF input signal, a second terminal electrically connectable to the first terminal, a third terminal electrically connectable to the first terminal, a fourth terminal electrically connectable to the second terminal, a first switch for connecting or disconnecting the first terminal and the third terminal, and a circuit including a second switch electrically connected to the first switch through a conductive line and configured to connect or disconnect the second terminal and the fourth terminal, an external element may be connected between the third terminal and the fourth terminal, based on a first control signal, the first switch may connect the first terminal and the conductive line, and the second switch may electrically connect the conductive line and the second terminal to form a first path through which the RF input signal is transmitted through the inside of the switch, and, based on a second control signal, the first switch may connect the first terminal and the third terminal, and the second switch connects the second terminal and the fourth terminal to form a second path through which the RF input signal is transmitted through the outside of the switch.

According to various embodiments, an electronic device include an antenna, a transceiver, and a switch connected between the antenna and the transceiver, the switch may include a first terminal for receiving an RF input signal from the transceiver, a second terminal electrically connectable to the first terminal, a third terminal electrically connectable to the first terminal, a fourth terminal electrically connectable to the second terminal, and a circuit electrically connected to the first terminal, the second terminal, the third terminal and the fourth terminal, based on a first control signal, the circuit may electrically connect the first terminal and the second terminal to form a first path through which the RF input signal is transmitted, and based on a second control signal, may connect the first terminal and the third terminal, and may connect the second terminal and the fourth terminal to form a second path through which the RF input signal is transmitted.

### [Advantageous Effects]

According to various embodiments, it is possible to efficiently design an RF circuit by providing a switch having a path selection function associated with an RF signal.

According to various embodiments, it is possible to provide a switch capable of switching between a first path to pass (bypass) a signal (e.g., an RF signal) from a first node to reach a second node between the first node and the second node and a second path that allows the signal from the first node to reach the second node via an external element (e.g., a filter, attenuator, amplifier or other external element).

According to various embodiments, it is possible to facilitate the provision of a first path between the antenna and the transmitter or receiver in the electronic device to pass (bypass) the signal from the antenna to reach the transmitter or receiver, and a second path for the signal from the antenna to reach the transmitter or receiver via an external element (e.g., a filter, attenuator, amplifier or other external element).

### [Brief Description of Drawings]

Other aspects, features, and benefits as described above of certain preferred embodiments of the present invention will become more apparent from the following description taken in conjunction with the accompanying drawings.
FIG. 1 is a diagram illustrating a switch according to an embodiment.
FIG. 2A is a diagram illustrating a switch including a first switch element connected to a first terminal and a second switch element connected to a second terminal, according to an embodiment.
FIG. 2B is a diagram illustrating a switch including a switch element connected to a first terminal and a branch circuit connected to a second terminal according to an embodiment.
FIG. 2C is a diagram illustrating a switch including a branch circuit connected to a first terminal and a switch element connected to a second terminal according to an embodiment.
FIG. 2D is a diagram illustrating a switch including a first branch circuit connected to a first terminal and a second branch circuit connected to a second terminal according to an embodiment.
FIG. 3 is a diagram illustrating a switch including an RF signal processing element on a first path by a connection between a first terminal and a second terminal according to an embodiment.
FIG. 4A is a diagram illustrating a switch to which an external device is connected according to an embodiment.
FIG. 4B is a diagram illustrating a first path in a switch to which an external device is connected according to an embodiment.
FIG. 4C is a diagram illustrating a second path in a switch to which an external device is connected according to an embodiment.
FIG. 5 is a diagram illustrating a switch including an RF signal processing element on a first path and an external device on a second path according to an embodiment.
FIG. 6 is a block diagram of an electronic device in a network environment according to an embodiment.
FIG. 7 is a diagram illustrating an electronic device including a switch on a transmission circuit according to an embodiment.
FIG. 8 is a diagram illustrating an electronic device including a switch on a receiving circuit according to an embodiment.
FIG. 9 is a diagram illustrating an electronic device including a switch on a coupler feedback path according to an embodiment.
FIG. 10 is a diagram illustrating an electronic device including a switch having a filter on a transmission circuit according to an embodiment.
FIG. 11 is a flowchart illustrating a method for controlling a switch in an electronic device according to an embodiment.

### [Mode for Carrying out the Invention]

The terms used in this document are only used to describe specific embodiments, and may not be intended to limit the scope of other embodiments. The singular expression may include the plural expression unless the context clearly dictates otherwise. All terms used herein, including technical or scientific terms, may have the same meaning as commonly understood by one of ordinary skill in the art of the present disclosure. The commonly used terms defined in the dictionary may be interpreted as having the same or similar meaning as the meaning in the context of the related art, and unless explicitly defined in this document, are not interpreted in an ideal or excessively formal meaning. In some cases, even terms defined in this document cannot be construed to exclude embodiments of the present invention.

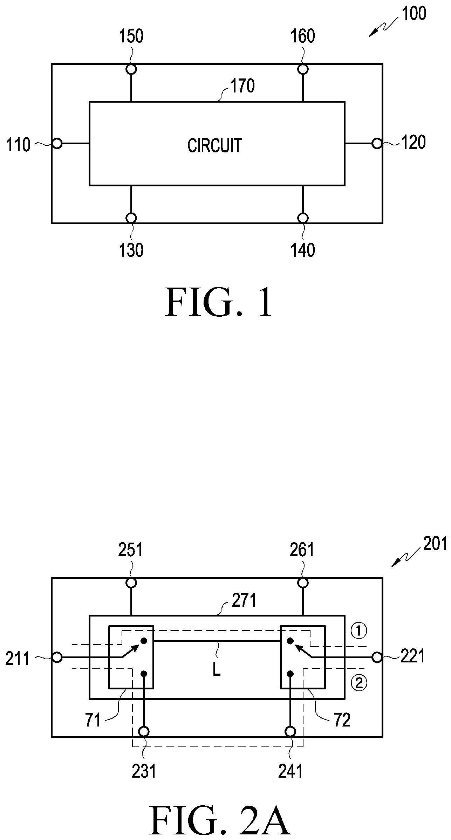

FIG. 1 is a diagram illustrating a switch 100 according to an embodiment.

Referring to FIG. 1, the switch 100 according to an embodiment may include a first terminal 110, a second terminal 120, a third terminal 130, a fourth terminal 140, a control terminal 150, a power terminal 160, and/or a circuit 170. For example, a terminal may be a port.

According to an embodiment, the first terminal 110 (hereinafter, also referred to as an 'input terminal') may receive a first input signal from the outside of the switch 100. According to an embodiment, the first input signal may be an RF signal.

According to an embodiment, the second terminal 120 (hereinafter, also referred to as an 'output terminal') may be electrically connected to or disconnected from the first terminal 110 through the circuit 170, and may be electrically connected to or disconnected from the fourth terminal 140 through the circuit 170. For example, the second terminal 120 may output the first input signal passing through the circuit 170 when connected to the first terminal 110. As another example, when the second terminal 120 may output the second input signal that is input from the fourth terminal 140 when connected to the fourth terminal 140.

According to an embodiment, the third terminal 130 may be electrically connected to or disconnected from the first terminal 110 through the circuit 170. For example, the third terminal 130 may output the first input signal when connected to the first terminal 110 through the circuit 170

According to an embodiment, the fourth terminal 140 may be electrically connected to or disconnected from the second terminal 120 through the circuit 170. For example, the fourth terminal 140 may receive a second input signal from the outside.

According to an embodiment, the control terminal 150 may control the operation of the circuit 170. According to an embodiment, the power terminal 160 may receive a voltage (or current, or power) from outside of the switch 100 to be used as a power source for operating the circuit 170.

According to an embodiment, the circuit 170 may allow the first terminal 110 and the second terminal 120 to be electrically connected through the inside of the switch 100 according to the control signal from the control terminal 150 to form a first path through which the first input signal is passed (bypassed), or may allow the first terminal 110 and the third terminal 130 to be connected, the second terminal 120 and the fourth terminal 140 to be connected, and the third terminal 130 and the fourth terminal 140 to be electrically connected through the outside of the switch 100 to form a second path through which the first input signal passes through an external device (or external electrical element) disposed outside the switch 100. According to an embodiment, although one control terminal 150 is exemplified, the switch 100 may include a plurality of control terminals according to a method of a control signal. For example, the plurality of control terminals may include an MIPI DATA terminal (or port) or an MIPI CLK (clock) terminal (or port) when using a mobile industry processor interface (MIPI) as a control signal, and may further include other ports.

According to an embodiment, when the first terminal 110 and the third terminal 130 are connected, the third terminal 130 and the fourth terminal 140 are electrically connected through an external device disposed outside the switch 100, and the second terminal 120 and the fourth terminal 140 are connected, the first input signal may be converted into a second input signal through an external device and input to the fourth terminal 140. For example, when the first input signal is input to the switch 100 through the first terminal 110, the first input signal may be output through the second terminal 120 through the first path. As another example, when the first input signal is input to the switch 100 through the first terminal 110, the first input signal may be changed to the second input signal and output through the second terminal 120 while passing through the second path.

According to various embodiments, the first input signal and the second input signal may be RF signals. According to various embodiments, the external device may include a element (e.g., an RF signal processing element) or a component that performs RF signal processing. For example, the RF signal processing element may include at least one of a filter, an attenuator, and an amplifier (low noise amplifier). According to various embodiments, an external device may be connected between the third terminal 130 and the fourth terminal 140. According to various embodiments, the circuit 170 may include at least one switch element.

FIG. 2A is a diagram illustrating a switch including a first switch element connected to a first terminal and a second switch element connected to a second terminal, according to an embodiment.

Referring to FIG. 2A, the switch 201 according to an embodiment may include a first terminal 211, a second terminal 221, a third terminal 231, a fourth terminal 241, a control terminal 251, a power terminal 261, a first switch element 71, and/or a second switch element 72. For example, the first switch element 71 and/or the second switch element 72 may be included in a circuit 271.

According to an embodiment, the first terminal 211 (e.g., input terminal) may receive a first input signal from the outside of the switch 201. According to an embodiment, the first input signal may be an RF signal.

According to an embodiment, the second terminal 221 (e.g., output terminal) may be electrically connected to or disconnected from the first terminal 211 through the first switch element 71 and the second switch element 72. According to an embodiment, the second terminal 221 may be electrically connected to or disconnected from the fourth terminal 241 through the second switch element 72. For example, when the second terminal 221 is connected to the first terminal 211 through the inside of the switch 201 using the first switch element 71 and the second switch element 72, the second terminal 221 may be input to the first terminal 211 and output the first input signal passing through the first switch element 71 and the second switch element 72. As another example, when the second terminal 221 is connected to the fourth terminal 241, the second terminal 221 may output the second input signal input from the fourth terminal 241. For example, the second input signal may be a signal obtained by processing the first input signal input to the first terminal 211 through the outside (e.g., external device) of the switch 201.

According to an embodiment, the third terminal 231 may be electrically connected to or disconnected from the first terminal 211 through the first switch element 71. For example, the third terminal 231 may output a first input signal when the third terminal 231 is electrically connected to the first terminal 211 through the first switch element 71.

According to an embodiment, the fourth terminal 241 may be electrically connected to or disconnected from the second terminal 221 through second switch element 72. For example, the fourth terminal 241 may receive the second input signal from the outside of the switch 201.

According to an embodiment, the control terminal 251 may control the operation of the first switch element 71 and/or the second switch element 72. According to an embodiment, the power supply terminal 261 may receive a voltage (or current, or power) from the outside of the switch 201 to be used as a power source for operating the first switch element 71 and the second switch element 72. According to an embodiment, it is exemplified that there is one control terminal 251, but the switch 201 may include a plurality of control terminals according to a method of a control signal. For example, when using MIPI as a control signal, the plurality of control terminals may include an MIPI DATA terminal (or port) or an MIPI CLK terminal (or port), and may further include other ports.

According to an embodiment, the first switch element 71 and the second switch element 72 may be electrically connected to each other. For example, the first switch element 71 and the second switch element 72 may be electrically connected to each other using a conductive line L.

According to an embodiment, the first switch element 71 and the second switch element 72 may electrically connect the first terminal 211 and the second terminal 221 according to a control signal (e.g., a first control signal) from the control terminal 251 to form a first path ① through which the first input signal passes (bypassed) through the inside of the switch 201. For example, the first switch element 71 may electrically connect the first terminal 211 and the conductive line L according to the first control signal, and the second switch element 72 may electrically connect the conductive line L and the second terminal 221 to form the first path ① through which the first input signal is passed (bypassed) through the inside of the switch 201.

According to an embodiment, the first switch element 71 may electrically connect the first terminal 211 and the third terminal 231 according to a control signal (e.g., second control signal) from the control terminal 251, and the second switch element 72 may electrically connect the second terminal 221 and the fourth terminal 241 to form a second path ② through which the first input signal passes through an external device (or external electrical element) disposed outside the switch 201. According to an embodiment, when the first terminal 211 and the third terminal 231 are connected, when the third terminal 231 and the fourth terminal 241 are connected through an external device, and when the second terminal 221 and the fourth terminal 241 are connected, the second input signal in which the first input signal is processed through the external device disposed outside the switch 201 may be input to the fourth terminal 241. The second input signal processed through the external device disposed outside the switch 201 may be output to the second terminal 221 connected to the fourth terminal 241.

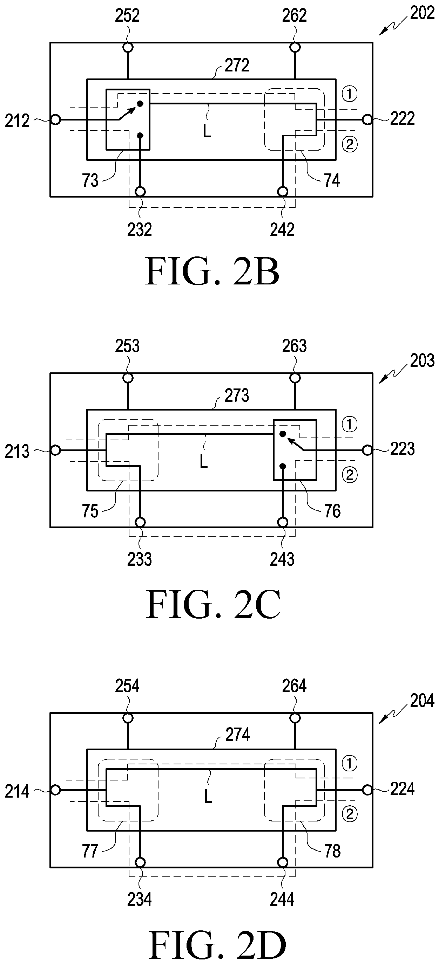

FIG. 2B is a diagram illustrating a switch including a switch element connected to a first terminal and a branch circuit connected to a second terminal according to an embodiment.

Referring to FIG. 2B, the switch 202 according to an embodiment may include a first terminal 212, a second terminal 222, a third terminal 232, a fourth terminal 242, a control terminal 252, a power terminal 262, a switch element 73, and/or a branch circuit 74. For example, the switch element 73 and/or the branch circuit 74 may be included in a circuit 272.

According to an embodiment, the first terminal 212 (e.g., input terminal) may receive a first input signal from the outside of the switch 202. According to an embodiment, the first input signal may be an RF signal.

According to an embodiment, the second terminal 222 (e.g., output terminal) may be electrically connected to or disconnected from the first terminal 212 through the switch element 73 and the branch circuit 74. According to an embodiment, the first terminal 222 may be electrically connected to or disconnected from the fourth terminal 242 through the branch circuit 74. For example, the second terminal 222 may output the first input signal that is input through the first terminal 212 and passes through the switch element 73 and the branch circuit 74 when electrically connected to the first terminal 212 through a conductive line L disposed inside the switch 201 using the switch element 73 and the branch circuit 74. For another example, when the second terminal 222 is connected to the fourth terminal 242, the second terminal 222 may output a second input signal that is input from the fourth terminal 242. For example, the second input signal may be a signal obtained by processing the first input signal input to the first terminal 221 through an external (e.g., external device) of the switch 202.

According to an embodiment, the third terminal 232 may be electrically connected to or disconnected from the first terminal 212 through the switch element 73. For example, the third terminal 232 may output the first input signal when electrically connected to the first terminal 212 through the switch element 73.

According to an embodiment, the fourth terminal 242 may be electrically connected to the second terminal 222 through the branch circuit 74. The fourth terminal 242 may receive the second input signal from the outside of the switch 202. When the fourth terminal 242 is electrically connected to the second terminal 222 through the branch circuit 74, the second input signal input to the fourth terminal 242 may be output to the second terminal 222. For example, the second input signal may be a signal obtained by passing the first input signal input through the first terminal 212 through an external device disposed outside the switch 202 .

According to an embodiment, the control terminal 252 may control the operation of the switch element 73 and/or the branch circuit 74. According to an embodiment, the power terminal 262 may receive a voltage (or current, or power) from outside of the switch 202 to be used as a power source for operating the switch element 73 and/or the branch circuit 74. According to an embodiment, one control terminal 252 is exemplified, but the switch 202 may include a plurality of control terminals depending on the method of the control signal. For example, the plurality of control terminals may include an MIPI DATA terminal (or port) or an MIPI CLK terminal (or port) when using MIPI as a control signal, and may further include other ports.

According to an embodiment, the switch element 73 and the branch circuit 74 may be electrically connected to each other. For example, the switch element 73 and the branch circuit 74 may be electrically connected to each other using a conductive line L.

According to an embodiment, the switch element 73 and/or the branch circuit 74 may connect the first terminal 212 and the second terminal 222 through inside of the circuit 272 according to a control signal (e.g., first control signal) from the control terminal 252 to form a first path (1) through which the first input signal input to the first terminal 212 is passed (bypassed) to the second terminal 222. For example, the first switch element 73 may electrically connect the first terminal 212 and the conductive line L and the branch circuit 74 may electrically connect the conductive line L and the second terminal according to the first control signal to form the first path (1) through which the first input signal passes inside the switch 202.

According to an embodiment, the switch element 73 may connect the first terminal 212 and the third terminal 232 and the branch circuit 74 may connect the second terminal 222 and the fourth terminal 242 according to the control signal (e.g., second control signal) from the control terminal 252 to form a second path ② through which the first input signal that is input to the first terminal 212 passes through an external device (or an external electrical device) disposed outside the switch 202 and the second input signal is output to the second terminal 222. According to an embodiment, when the first terminal 212 and the third terminal 232 are connected, when the third terminal 232 and the fourth terminal 242 are connected through an external device disposed outside of the switch 202, and when the second terminal 222 and the fourth terminal 242 are connected, the first input signal may be processed through an external device and input to the fourth terminal 242 as the second input signal, based on the second path. The second input signal obtained by processing the first input signal through the external device disposed outside of the switch 202 may be output to the second terminal 222 connected to the fourth terminal 242.

FIG. 2C is a diagram illustrating a switch including a branch circuit connected to a first terminal and a switch element connected to a second terminal according to an embodiment.

Referring to FIG. 2C, the switch 203 according to an embodiment may include a first terminal 213, a second terminal 223, a third terminal 233, a fourth terminal 243, a control terminal 253, a power terminal 263, a branch circuit 75, and/or a switch element 76. For example, the branch circuit 75 and/or the switch element 76 may be included in a circuit 273.

According to an embodiment, the first terminal 213 (e.g., input terminal) may receive a first input signal from outside of the switch 203. According to an embodiment, the first input signal may be an RF signal.

According to an embodiment, the second terminal 223 (e.g., output terminal) may be electrically connected to the first terminal 213 through the branch circuit 75 and the switch element 76. According to an embodiment, the second terminal 223 may be electrically connected to the fourth terminal 243 through the switch element 76. For example, when connected to the first terminal 213 through a conductive path L disposed inside of the switch 203 using the branch circuit 73 and the switch element 74, the second terminal 223 may output the first input signal that is input through the first terminal 213 and passes the branch circuit 75 and the switch element 76. As another example, the second terminal 223 may output the second input signal that is input from the fourth terminal 243 when connected to the fourth terminal 243. For example, the second input signal may be a signal obtained by processing the first input signal that is input to the first terminal 213 through the outside (e.g., external device) of the switch 203.

According to an embodiment, the third terminal 233 may be electrically connected to the first terminal 213 through the branch circuit 75. For example, the third terminal 233 may output the first input signal when electrically connected to the first terminal 213 through the branch circuit 75.

According to an embodiment, the fourth terminal 243 may be electrically connected to or disconnected from the second terminal 223 through the switch element 76. The fourth terminal 243 may receive a second input signal from outside. When the fourth terminal 242 is connected to the second terminal 222 through the switch element 76, the second input signal that is input to the fourth terminal 242 may be output to the second terminal 222. For example, the second input signal may be a signal obtained by passing the first input signal input through the first terminal 213 through an external device disposed outside the switch 203.

According to an embodiment, the control terminal 253 may control the operation of the branch circuit 75 and/or the switch element 76. According to an embodiment, the power terminal 263 may receive a voltage (or current, or power) from the outside of the switch 203 to be used as a power source for operating the branch circuit 75 and/or the switch element 76. According to an embodiment, it is exemplified that there is one control terminal 253, but the switch 203 may include a plurality of control terminals according to the method of the control signal. For example, when using MIPI as a control signal, the plurality of control terminals may include an MIPI DATA terminal (or port) or an MIPI CLK terminal (or port), and may further include other ports.

According to an embodiment, the branch circuit 75 and the switch element 76 may be electrically connected. For example, the branch circuit 75 and the switch element 76 may be electrically connected using a conductive line L.

According to an embodiment, when the first terminal 213 and the second terminal 223 are connected to the inside of the circuit 273 through the branch circuit 75 and the switch element 76 according to a control signal (e.g., first control signal) from the control terminal 253, a first path (1) through which the first input signal input to the first terminal 213 passes (bypasses) to the second terminal 223 may be formed. For example, the branch circuit 75 may electrically connect the first terminal 213 and the conductive line L and the switch element 76 may electrically connect the conductive line L and the second terminal 223 according to the first control signal to form the first path ① through which the first input signal is passed (bypassed) through the inside of the switch 203.

According to an embodiment, when the branch circuit 253 connects the first terminal 213 and the third terminal 233 and the switch element 76 connects the second terminal 223 and the fourth terminal 243 according to the control signal (e.g., second control signal) from the control terminal 253, a second path ② through which the first input signal passes through an external device (or an external electrical device) disposed outside the switch 203 is output to the second terminal 223 may be formed. For example, when the first terminal 213 and the third terminal 233 are connected, when the third terminal 233 and the fourth terminal 243 are connected through the external device disposed outside of the switch 203, and when the second terminal 223 and the fourth terminal 243 are connected, the second input signal obtained by processing the first input signal through the external device may be input to the fourth terminal 243. The second input signal obtained by processing the first input signal through the external device disposed outside the switch 203 may be output to the second terminal 223 connected to the fourth terminal 243.

FIG. 2D is a diagram illustrating a switch including a first branch circuit connected to a first terminal and a second branch circuit connected to a second terminal according to an embodiment.

Referring to FIG. 2D, the switch 204 according to an embodiment may include a first terminal 214, a second terminal 224, a third terminal 234, a fourth terminal 244, a control terminal 254, a power terminal 264, a first branch circuit 77, and/or a second branch circuit 78. For example, the first branch circuit 77 and/or the second branch circuit 78 may be included in a circuit 274. According to an embodiment, the first terminal 214 (e.g., input terminal) may receive a first input signal from outside of the switch 204. According to an embodiment, the first input signal may be an RF signal.

According to an embodiment, the second terminal 224 (e.g., output terminal) may be electrically connected to the first terminal 214 through the first branch circuit 77 and/or the second branch circuit 78. According to an embodiment, the second terminal 224 may be electrically connected to the fourth terminal 244 through the second branch circuit 78. For example, the second terminal 224 may output a first input signal from the first terminal 214 when electrically connected to the first terminal 214 through a conductive path L disposed inside of the switch 204 using the first branch circuit 77 and the second branch circuit 78. As another example, when the second terminal 224 is not connected to the first terminal 214, but is electrically connected to the fourth terminal 244 through the second branch circuit 78 from the fourth terminal 244, the second terminal 224 may output a second input signal input from the fourth terminal 244. For example, the second input signal may be a signal obtained by processing the first input signal through the outside (e.g., external device) of the switch 204 .

According to an embodiment, the third terminal 234 may be electrically connected to the first terminal through the first branch circuit 77. For example, the third terminal 234 may output the first input signal from the first terminal 214 when electrically connected to the first terminal 214 through the first branch circuit 77.

According to an embodiment, the fourth terminal 244 may be electrically connected to the second terminal 224 through the second branch circuit 78. For example, the fourth terminal 244 may receive the second input signal from outside, and when electrically connected to the second terminal 224 through the second branch circuit 78, the second input signal may be output though the fourth terminal 244. For example, the second input signal may be a signal obtained by passing the first input signal that is input through the first terminal 214 through an external device disposed outside of the switch 204.

According to an embodiment, the control terminal 254 may control the first branch circuit 77 and/or the second branch circuit 78. According to an embodiment, the power terminal 264 may receive a voltage (or current, or power) from outside to be used as a power source required for operating the first branch circuit 77 and/or the second branch circuit 78. According to an embodiment, although one control terminal 252 is exemplified, the switch 204 may include a plurality of control terminals according to a method of a control signal. For example, when using MIPI as a control signal, the plurality of control terminals may include an MIPI DATA terminal (or port) or an MIPI CLK terminal (or port), and may further include other ports.

According to an embodiment, the first branch circuit 77 and the second branch circuit 78 may be electrically connected. For example, the first branch circuit 77 and the second branch circuit 78 may be electrically connected using a conductive line L.

According to an embodiment, when the first terminal 214 and the second terminal 224 are electrically connected by the first branch circuit 77 and the second branch circuit 78 according to a control signal (e.g., a first control signal) from the control terminal 254, a first path ① may be formed in the circuit 274 through which the first input signal input to the first terminal 214 is passed (bypassed) to the second terminal 224. For example, according to a first control signal, the first branch circuit 77 may electrically connect the first terminal 214 and the conductive line L and the second branch circuit 78 may electrically connect the conductive line L and the second terminal 224 to form the first path ① through which the first input signal is passed (bypassed) through the inside of the switch 204.

According to an embodiment, according to a control signal from the control terminal 254, when the first terminal 214 and the third terminal 234 are electrically connected through the first branch circuit 77 and the second terminal 224 and the fourth terminal 244 are electrically connected through the second branch circuit 78, a second path ② through which the first input signal passes through an external device (or external electrical device) disposed outside the switch 204 is output to the second terminal 224 may be formed. For example, when the first terminal 214 and the third terminal 234 are electrically connected, when the third terminal 234 and the fourth terminal 244 are electrically connected through an external device disposed outside of the switch 204, and when the second terminal 224 and the fourth terminal 244 are connected, a second input signal obtained by passing the first input signal through an external device may be input to the fourth terminal 244. The second input signal obtained by passing the first input signal through the external device disposed outside of the switch 204 may be output to the second terminal 224 electrically connected to the fourth terminal 244.

According to an embodiment, the first branch circuit 77 and/or the second branch circuit 78 may perform connection and disconnection operations regardless of a control signal and/or power supply. According to an embodiment, when a control signal is not required for the first branch circuit 77 and/or the second branch circuit 78, the control terminal 254 might not be included in the switch circuit 204. According to an embodiment, when power supply is not required to the first branch circuit 77 and/or the second branch circuit 78, the power terminal 264 might not be included in the switch circuit 204.

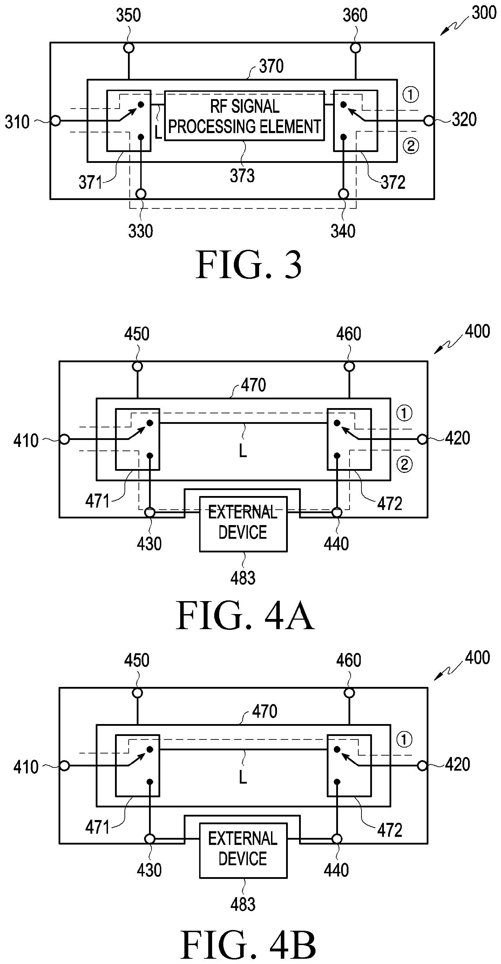

FIG. 3 is a diagram illustrating a switch including an RF signal processing element on a first path by a connection between a first terminal and a second terminal according to an embodiment.

Referring to FIG. 3, the switch 300 according to an embodiment may include a first terminal 310, a second terminal 320, a third terminal 330, a fourth terminal 340, a control terminal 350, a power terminal 360, a first switch element 371, a second switch element 372, and/or an RF signal processing element 373. For example, the RF signal processing element 373 may include a filter, amplifier, and/or an attenuator. As another example, the switch 300 may include a plurality of RF signal processing elements.

According to an embodiment, the first terminal 310 (e.g., input terminal) may receive a first input signal from outside of the switch 300. According to an embodiment, the first input signal may be an RF signal.

According to an embodiment, the second terminal 320 (e.g., output terminal) may be electrically connected to the first terminal 310 through the first switch element 371, the second switch element 372, and/or the RF signal processing element 373. For example, when the second terminal 320 is electrically connected to the first terminal 310 through inside the switch 300 using the first switch element 371, the second switch element 372, and/or the RF signal processing element 373, the first input signal from the first terminal 310 may be signal-processed (e.g., filtered, attenuated, and/or amplified) through the RF signal processing element 373 and output to the second terminal 320. According to an embodiment, the second terminal 320 may be electrically connected to the fourth terminal 340 through the second switch element 372. For example, when electrically connected to the fourth terminal 340, the second terminal 320 may output a second input signal that is input from the fourth terminal 244. For example, the second input signal may be a signal obtained by passing the first input signal input through the first terminal 310, through an external device disposed outside the switch 300

According to an embodiment, the third terminal 330 may be electrically connected to the first terminal 310 through the first circuit 371. For example, the third terminal 330 may output the first input signal from the first terminal 310 when electrically connected to the first terminal 310.

According to an embodiment, the fourth terminal 340 may be electrically connected to the second terminal 320 through the second switch element 372. For example, when the fourth terminal 340 is capable of receiving a second input signal from outside of the switch 300 and is connected to the second terminal 320 through the second switch element 732, the second input signal may be output through the second terminal 320. For example, the second input signal may be a signal obtained by passing the first input signal input through the first terminal through the external device disposed outside of the switch 300.

According to an embodiment, the control terminal 350 may control the first switch element 371 and/or the second switch element 372. According to an embodiment, the control terminal 360 may receive a voltage (or current, or power) from outside of the switch 300 to be used as a power source for operating the first switch element 371 and/or the second switch element 372. According to an embodiment, it is exemplified that there is one control terminal 350, but the switch circuit 300 may include a plurality of control terminals according to the method of the control signal. For example, when using MIPI as a control signal, the plurality of control terminals may include an MIPI DATA terminal (or port) or an MIPI CLK terminal (or port), and may further include other ports.

According to an embodiment, the first switch element 371, the RF signal processing element 373, and the second switch element 372 may be electrically connected. For example, the first switch element 371, the RF signal processing element 373, and the second switch element 372 may be electrically connected using a conductive line L.

According to an embodiment, when the first terminal 310, the RF signal processing element 373, or the second terminal 320 are connected through inside the switch 300 by the first switch element 371 and/or the second switch element 372 according to a control signal (e.g., first control signal) from the control terminal 350, the first input signal input to the first terminal 310 may be output as a third input signal through the RF signal processing element 373 and input to the second terminal 320, and a first path ① associated with the first terminal 310, the RF signal processing element 373, and the second terminal 320 may be formed. For example, according to the first control signal, the first switch element 371 may electrically connect the first terminal 310 and the conductive line L, and the first switch element 371 may electrically connect the conductive line L and the second terminal 320 to form a first path ① through which the first input signal is output as a third input signal through the RF signal processing element 373 inside the switch 300 and is input to the second terminal 320.

According to an embodiment, when the first terminal 310 and the third terminal 320 are connected through the first switch element 371 and the second terminal 320 and the fourth terminal 340 are connected through the second switch element 372 according to a control signal from the control terminal 350, the first input signal may be output as a second input signal through an external device (or external electrical device) disposed outside the switch 300 and input to the second terminal 320, and a second path ② associated with the first terminal 310, the third terminal 320, an external device, the second terminal 320, or the fourth terminal 340 may be formed. For example, when the first terminal 310 and the third terminal 330 are connected, when the third terminal 330 and the fourth terminal 340 are connected through an external device, and when the second terminal 320 and the fourth terminal 340 are connected, a second input signal obtained by passing the first input signal through the third terminal 330, an external device (not shown), and the fourth terminal 340 may be output to the second terminal 320.

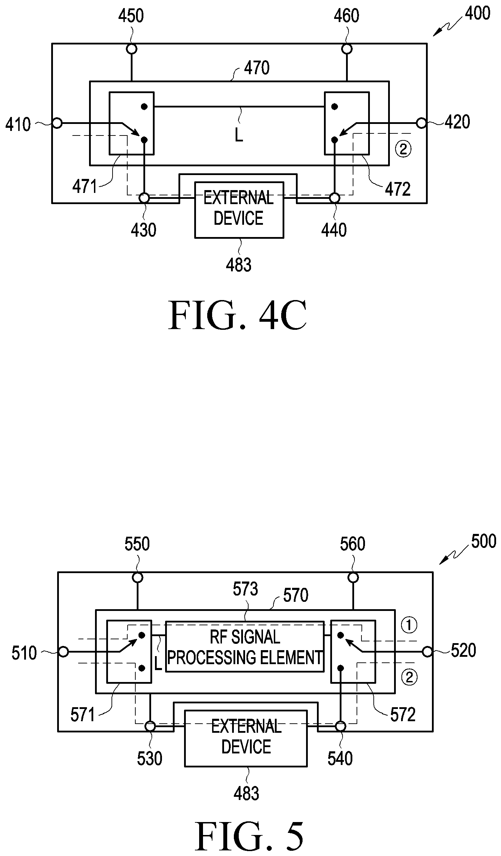

FIG. 4A is a diagram illustrating a switch to which an external device is connected according to an embodiment, FIG. 4B is a diagram illustrating a first path in the switch to which an external device is connected according to an embodiment, and FIG. 4C is a diagram illustrating a second path in the switch to which an external device is connected according to an embodiment.

Referring to FIG. 4A, the switch 400 according to an embodiment may include a circuit including a first terminal 410, a second terminal 420, a third terminal 430, a fourth terminal 440, a control terminal 450, a power terminal 460, a first switch element 471, and a second switch element 472, and at least one external device 483 (or an external electrical device) (e.g., a filter, an amplifier, or an attenuator) may be disposed (or connected) between the second terminal 420 and the third terminal 430. According to an embodiment, the first terminal 410 (e.g., an input terminal) may receive a first input signal from the outside of the switch 400. According to an embodiment, the first input signal may be an RF signal.

According to an embodiment, the second terminal 420 (e.g., output terminal) may be electrically connected to the first terminal 410 through the first switch element 471 and the second switch element 472. For example, when the second terminal 420 is connected to the first terminal 410 through the inside of the switch 400 through the first switch element 471 and the second switch element 472, the first input signal from the first terminal 410 may be bypassed and output to the second terminal 420. According to an embodiment, the second terminal may be connected to the fourth terminal 440 through the second switch element 472. When connected to the fourth terminal 440, the second terminal 420 may output a second input signal input from the fourth terminal 440. For example, the second input signal may be a signal obtained by processing the first input signal input to the first terminal through the external device 483 outside of the switch 400.

According to an embodiment, the third terminal 430 may be electrically connected to the first terminal 410 through the first switch element 471.

According to an embodiment, the fourth terminal 440 may be electrically connected to the second terminal 420 through the second switch element 472.

According to an embodiment, an external device 483 may be disposed (or connected) to a path that electrically connects the third terminal 430 and the fourth terminal 440.

According to an embodiment, when the third terminal 430 and the first terminal 410 are connected and the fourth terminal 440 and the second terminal 420 are connected, a first input signal from the first terminal 410 may be input as a second input signal to the fourth terminal 440 through the third terminal 430 and the external device 483, and the second input signal may be output through the second switch element 472 through the fourth terminal 440.

According to an embodiment, the control terminal 450 may control the first switch element 471 and/or the second switch element 472. According to an embodiment, the power terminal 460 may receive a voltage (or current, or power) from outside of the switch 400 to be used as a power source for operating the first switch element 471 and/or the second switch element 472.

According to an embodiment, the first switch element 471 and or the second switch element 472 may be electrically connected. For example, the first switch element 471 and the second switch element 472 may be electrically connected using a conductive line L.

Referring to FIG. 4B, a first path ① through which the first terminal 410 and the second terminal 420 are electrically connected through the inside of the switch 400 by the first switch element 471 and the second switch element 472 may be formed according to a control signal (e.g., first control signal) from the control terminal 450. Based on the first path ①, the first input signal input to the first terminal 410 may be bypassed and output to the second terminal 420. For example, according to the first control signal, the first switch element 471 may electrically connect the first terminal 410 and the conductive line L, and the second switch element 472 may electrically connect the conductive line L and the second terminal 420 to form the first path ① through which the first input signal is passed (bypassed) through the inside of the switch 400.

Referring to FIG. 4C, the first terminal 410 and the third terminal 420 may be electrically connected through the first switch element 471, and the second terminal 420 and the fourth terminal 440 may be electrically connected through the second switch element 472 according to a control signal (e.g., second control signal) from the control terminal 450, so that a second path ② through which the first terminal 410, the third terminal 420, the external device 483, the fourth terminal 440, and the second terminal 420 are electrically connected may be formed. Based on the second path ②, the first input signal may be output to the second terminal 420 through the first terminal 410, the third terminal 430, the external device 483, and the fourth terminal 440.

FIG. 5 is a diagram illustrating a switch including an RF signal processing element on a first path and an external device on a second path according to an embodiment.

Referring to FIG. 5, the switch 500 according to an embodiment may include a first terminal 510, a second terminal 520, a third terminal 530, a fourth terminal 540, a control terminal 550, a power terminal 560, a first switch element 571, a second switch element 572, and/or an RF signal processing element 573. For example, the first switch element 571, the second switch element 572, and/or the RF signal processing element 573 may be included in a circuit 570. For another example, the external device 583 may be disposed outside of the switch 500, and may be connected between the third terminal 530 and the fourth terminal 540. For example, the RF signal processing element 573 or the external device 583 may include at least one of a filter, an amplifier, and/or an attenuator.

According to an embodiment, the first terminal 510 (e.g., an input terminal) may receive a first input signal from the outside of the switch 500. According to an embodiment, the first input signal may be an RF signal.

According to an embodiment, the second terminal 520 (e.g., output terminal) may be electrically connected to the first terminal 510 through the inside of the switch 500 through the first switch element 571, the second switch element 572, and/or the RF signal processing element 573. For example, when the second terminal 520 is connected to the first terminal 510 through the inside of the switch 500 using the first switch element 571, the second switch element 572, and/or the RF signal processing element 573, the first input signal from the first terminal 510 may be processed (e.g., filtered, amplified, or attenuated) through the RF signal processing element 573 and output as a third signal to the second terminal 520. According to an embodiment, the second terminal 520 may be connected to the fourth terminal 540 through the second switch element 572. When connected to the fourth terminal 540, the second terminal 520 may output a second input signal input from the fourth terminal 540. For example, the second input signal may be a signal obtained by processing the first input signal input to the first terminal through the external device 583 outside of the switch 500.

According to an embodiment, the third terminal 530 may be electrically connected to the first terminal 510 through the first circuit device 571. According to an embodiment, the fourth terminal 540 may be electrically connected to the second terminal 520 through the second switch element 572. According to an embodiment, a second filter 583 (e.g., external device) may be disposed (or connected) on a path through which the third terminal 530 and the fourth terminal 540 are connected.

According to an embodiment, when the third terminal 530 and the first terminal 510 are electrically connected and the fourth terminal 540 and the second terminal 520 are electrically connected, the first input signal from the first terminal 510 may be input as a second input signal to the fourth terminal 540 through the third terminal 530 and the second filter 583, and the second input signal input through the fourth terminal 540 may be output to the second terminal 520 through the second switch element 572.

According to an embodiment, the control terminal 550 may control the first switch element 571 and/or the second switch element 572. According to an embodiment, the power terminal 560 may receive a voltage (or current, or power) from outside to be used as a power source for operating the first switch element 571 and/or the second switch element 572.

According to an embodiment, when the first terminal 510, the RF signal processing element 573, and the second terminal 520 are electrically connected by the first switch element 571 and the second switch element 572 according to a control signal (e.g., first control signal) from the control terminal 550, a first path ① may be formed in which the first input signal input to the first terminal 510 is processed by the RF signal processing element 573 and output to the second terminal 520 as a third input signal. For example, the first switch element 571 may electrically connect the first terminal 510 and the conductive line L and the second switch element 572 may electrically connect the conductive line L and the second terminal 520 according to the first control signal to form the first path ① through which the first input signal passes through the RF signal processing element 573 inside the switch 500.

According to an embodiment, when the first terminal 510 and the third terminal 530 are electrically connected through the first switch element 571 and the second terminal 520 and the fourth terminal 540 are electrically connected through the second switch element 572 according to a control signal (e.g., first control signal) from the control terminal 550, a second path ② through which the first input signal is output to the second terminal 520 through the external device 583 may be formed. For example, when the first terminal 510 and the third terminal 530 are electrically connected, when the third terminal 530 and the fourth terminal 540 are electrically connected through the external device 582, and when the second terminal 520 and the fourth terminal 540 are electrically connected, the first input signal may be processed through the third terminal 530, the external device 583, and/or the fourth terminal 540 to be output to the second terminal 520 as a second input signal.

According to various embodiments, the switch (e.g., the switch 100 of FIG. 1, the switch 201 of FIG. 2A, the switch 202 of FIG. 2B, the switch 203 of FIG. 2C, the switch 204 of FIG. 2D, the switch 300 of FIG. 3, the switch 400 of FIGS. 4A to 4C, or the switch 500 of FIG. 5) may be included and used in various electronic devices.

According to various embodiments, the switch (e.g., the switch 100 of FIG. 1, the switch 201 of FIG. 2A, the switch 202 of FIG. 2B, the switch 203 of FIG. 2C, the switch 204 of FIG. 2D, the switch 300 of FIG. 3, the switch 400 of FIGS. 4A to 4C, or the switch 500 of FIG. 5) may receive a control signal and a voltage (or current, or power) in a different manner without a separate control terminal and a power terminal, or may not receive a control signal and a voltage (or current, or power).

According to various embodiments, the switch (e.g., the switch 100 of FIG. 1, the switch 201 of FIG. 2A, the switch 202 of FIG. 2B, the switch 203 of FIG. 2C, the switch 204 of FIG. 2D, the switch 300 of FIG. 3, the switch 400 of FIGS. 4A to 4C, or the switch 500 of FIG. 5) may include a first terminal (e.g., the first terminal 110 of FIG. 1, the first terminal 211 of FIG. 2A, the first terminal 221 of FIG. 2B, the first terminal 231 of FIG. 2C, the first terminal 241 of FIG. 2D, the first terminal 310 of FIG. 3, the first terminal 410 of FIGS. 4A to 4C, or the first terminal 510 of FIG. 5) for receiving an RF signal, a second terminal (e.g., the second terminal 120 of FIG. 1, the second terminal 221 of FIG. 2A, the second terminal 222 of FIG. 2B, the second terminal 223 of FIG. 2C, the second terminal 224 of FIG. 2D, the second terminal 320 of FIG. 3, the second terminal 420 of FIGS. 4A to 4C, or the second terminal 520 of FIG. 5) that is electrically connectable to the first terminal, a third terminal (e.g., the third terminal 130 of FIG. 1, the third terminal 231 of FIG. 2A, the third terminal 232 of FIG. 2B, the third terminal 233 of FIG. 2C, the third terminal 234 of FIG. 2D, the third terminal 330 of FIG. 3, the third terminal 430 of FIGS. 4A to 4C, or the third terminal 530 of FIG. 5) that is electrically connectable to the first terminal, a fourth terminal (e.g., the fourth terminal 140 of FIG. 1, the fourth terminal 241 of FIG. 2A, the fourth terminal 242 of FIG. 2B, the fourth terminal 243 of FIG. 2C, the fourth terminal 244 of FIG. 2D, the fourth terminal 340 of FIG. 3, the fourth terminal 440 of FIGS. 4A to 4C, or the fourth terminal 540 of FIG. 5) that is electrically connectable to the second terminal, and a circuit (e.g., the circuit 170 of FIG. 1, the circuit 271 of FIG. 2A, the circuit 272 of FIG. 2B, the circuit 273 of FIG. 2C, the circuit 274 of FIG. 2D, the circuit 370 of FIG. 3, the circuit 470 of FIGS. 4A to 4C, or the circuit 570 of FIG. 5) that electrically connects the first terminal and the second terminal based on a first control signal to form a first path through which the RF input signal is transmitted, connects the first terminal and the third terminal based on a second control signal, and connects the second terminal and the fourth terminal to form a second path through which the RF input signal is transmitted.

According to an embodiment, the circuit may include a first switch element (e.g., the first switch element 71 of FIG. 2A) electrically connected to the first terminal and the third terminal, and a second switch element 72 connected to the first switch through a conductive line L and electrically connected to the second terminal and the fourth terminal, the first switch element may connect the first terminal and the conductive line and the second switch element may connect the conductive line and the second terminal, based on the first control signal to form the first path through the inside of the switch, and the first switch element may connect the first terminal and the third terminal and the second switch element may connect the second terminal and the fourth terminal, based on the second control signal to form the second path through the outside of the switch.

According to an embodiment, the circuit may include a switch element (e.g., the first switch element 73 of FIG. 2B) electrically connected to the first terminal and the third terminal, and a branch circuit (e.g., the branch circuit 74 of FIG. 2B) electrically connected to the switch element through a conductive line and electrically connected to the second terminal and the fourth terminal, the switch element may connect the first terminal and the conductive line and the branch circuit may connect the conductive line and the second terminal, based on the first control signal to form the first path through the inside of the switch, and the switch element may connect the first terminal and the third terminal and the branch circuit may connect the second terminal and the fourth terminal, based on the second control signal to form the second path through the outside of the switch.

According to an embodiment, the circuit may include a branch circuit (e.g., the branch circuit 75 of FIG. 2C) electrically connected to the first terminal and the third terminal, and a switch element (e.g., the switch element 76 of FIG. 2C) connected to the branch circuit through a conductive line and electrically connected to the second terminal and the fourth terminal, the switch element may connect the first terminal and the conductive line and the branch circuit may connect the conductive line and the second terminal, based on the first control signal to form the first path through the inside of the switch, and the branch circuit may connect the first terminal and the third terminal and the switch element may connect the second terminal and the fourth terminal, based on the second control signal to form the second path through the outside of the switch.

According to an embodiment, the circuit may include a first branch circuit (e.g., the first branch circuit 77 of FIG. 2D) and a second branch circuit (e.g., the second branch circuit 78 of FIG. 2D) connected to the first branch circuit through a conductive line and electrically connected to the second terminal and the fourth terminal, the first branch circuit may connect the first terminal and the conductive line and the second branch circuit may connect the conductive line and the second terminal, based on the first control signal to form the first path through the inside the switch, and the first branch circuit may connect the first terminal and the third terminal and the second branch may connect the second terminal and the fourth terminal, based on the second control signal to form the second path through the outside of the switch.

According to an embodiment, in the switch, an external device (e.g., the external device 483 of FIGS. 4A to 4C, or the external device 583 of FIG. 5) may be connected between the third terminal and the fourth terminal.

According to an embodiment, the switch may include an RF signal processing element (e.g., the RF signal processing element 373 of FIG. 3, or the RF signal processing element 573 of FIG. 5) connected between the first switch element and the second switch element.

According to an embodiment, the RF processing element or the external device may include at least one of a filter, an attenuator, or an amplifier.

According to various embodiments, the switch (e.g., the switch 100 of FIG. 1, the switch 201 of FIG. 2A, the switch 202 of FIG. 2B, the switch 203 of FIG. 2C, the switch 204 of FIG. 2D, the switch 300 of FIG. 3, the switch 400 of FIGS. 4A to 4C, or the switch 500 of FIG. 5) may include a first terminal (e.g., the first terminal 110 of FIG. 1, the first terminal 211 of FIG. 2A, the first terminal 221 of FIG. 2B, the first terminal 231 of FIG. 2C, the first terminal 241 of FIG. 2D, the first terminal 310 of FIG. 3, the first terminal 410 of FIGS. 4A to 4C, or the first terminal 510 of FIG. 5) for receiving an RF signal, a second terminal (e.g., the second terminal 120 of FIG. 1, the second terminal 221 of FIG. 2A, the second terminal 222 of FIG. 2B, the second terminal 223 of FIG. 2C, the second terminal 224 of FIG. 2D, the second terminal 320 of FIG. 3, the second terminal 420 of FIGS. 4A to 4C, or the second terminal 520 of FIG. 5) that is electrically connectable to the first terminal, a third terminal (e.g., the third terminal 130 of FIG. 1, the third terminal 231 of FIG. 2A, the third terminal 232 of FIG. 2B, the third terminal 233 of FIG. 2C, the third terminal 234 of FIG. 2D, the third terminal 330 of FIG. 3, the third terminal 430 of FIGS. 4A to 4C, or the third terminal 530 of FIG. 5) that is electrically connectable to the first terminal, a fourth terminal (e.g., the fourth terminal 140 of FIG. 1, the fourth terminal 241 of FIG. 2A, the fourth terminal 242 of FIG. 2B, the fourth terminal 243 of FIG. 2C, the fourth terminal 244 of FIG. 2D, the fourth terminal 340 of FIG. 3, the fourth terminal 440 of FIGS. 4A to 4C, or the fourth terminal 540 of FIG. 5) that is electrically connectable to the second terminal, and a circuit including a first switch (e.g., the first switch element 71 of FIG. 2A) that connects or disconnects the first terminal and the third terminal and a second switch (e.g., the second switch element 72 of FIG. 2A) that is electrically connected to the first switch element (through a conductive line) and connects or disconnects the second terminal and the fourth terminal, an external device may be connected between the third terminal and the fourth terminal, the first switch may connect the first terminal and the second switch (the conductive line) based on a first control signal, and the second switch electrically connects the first switch (with the conductive line) and the second terminal to form a first path through which the RF input signal is transmitted through the inside of the switch, the first switch may connect the first terminal and the third terminal based on a second control signal, and the second switch may connect the second terminal and the fourth terminal to form a second path through which the RF input signal is transmitted through the outside of the switch.

According to an embodiment, an RF signal processing element (e.g., the RF signal processing element 373 of FIG. 3 or the RF signal processing element 573 of FIG. 5) connected between the first switch and the second switch may be included.

According to an embodiment, the RF signal processing element or the external device (e.g., the external device 483 of FIGS. 4A to 4C or the external device 583 of FIG. 5) may include at least one of a filter, an attenuator, and an amplifier.

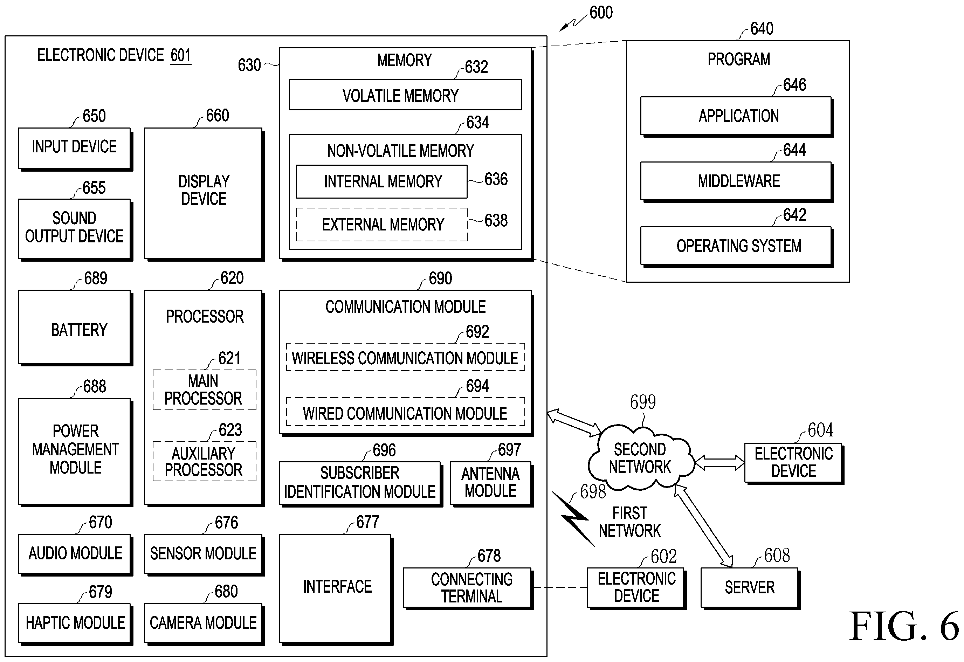

FIG. 6 is a block diagram illustrating an electronic device 601 in a network environment 600 according to various embodiments.

Referring to FIG. 6, the electronic device 601 in the network environment 600 may communicate with an electronic device 602 via a first network 698 (e.g., a short-range wireless communication network), or an electronic device 604 or a server 608 via a second network 699 (e.g., a long-range wireless communication network). According to an embodiment, the electronic device 601 may communicate with the electronic device 604 via the server 608. According to an embodiment, the electronic device 601 may include a processor 620, memory 630, an input device 650, a sound output device 655, a display device 660, an audio module 670, a sensor module 676, an interface 677, a haptic module 679, a camera module 680, a power management module 688, a battery 689, a communication module 690, a subscriber identification module (SIM) 696, or an antenna module 697. In some embodiments, at least one (e.g., the display device 660 or the camera module 680) of the components may be omitted from the electronic device 601, or one or more other components may be added in the electronic device 601. In some embodiments, some of the components may be implemented as single integrated circuitry. For example, the sensor module 676 (e.g., a fingerprint sensor, an iris sensor, or an illuminance sensor) may be implemented as embedded in the display device 660 (e.g., a display).

The processor 620 may execute, for example, software (e.g., a program 640) to control at least one other component (e.g., a hardware or software component) of the electronic device 601 coupled with the processor 620, and may perform various data processing or computation. According to one embodiment, as at least part of the data processing or computation, the processor 620 may load a command or data received from another component (e.g., the sensor module 676 or the communication module 690) in volatile memory 632, process the command or the data stored in the volatile memory 632, and store resulting data in non-volatile memory 634. According to an embodiment, the processor 620 may include a main processor 621 (e.g., a central processing unit (CPU) or an application processor (AP)), and an auxiliary processor 623 (e.g., a graphics processing unit (GPU), an image signal processor (ISP), a sensor hub processor, or a communication processor (CP)) that is operable independently from, or in conjunction with, the main processor 621. Additionally or alternatively, the auxiliary processor 623 may be adapted to consume less power than the main processor 621, or to be specific to a specified function. The auxiliary processor 623 may be implemented as separate from, or as part of the main processor 621.

The auxiliary processor 623 may control, for example, at least some of functions or states related to at least one component (e.g., the display device 660, the sensor module 676, or the communication module 690) among the components of the electronic device 601, instead of the main processor 621 while the main processor 621 is in an inactive (e.g., sleep) state, or together with the main processor 621 while the main processor 621 is in an active (e.g., executing an application) state. According to an embodiment, the auxiliary processor 623 (e.g., an image signal processor or a communication processor) may be implemented as part of another component (e.g., the camera module 680 or the communication module 690) functionally related to the auxiliary processor 623.

The memory 630 may store various data used by at least one component (e.g., the processor 620 or the sensor module 676) of the electronic device 601. The various data may include, for example, software (e.g., the program 640) and input data or output data for a command related thereto. The memory 630 may include the volatile memory 632 or the non-volatile memory 634.

The program 640 may be stored in the memory 630 as software, and may include, for example, an operating system (OS) 642, middleware 644, or an application 646.

The input device 650 may receive a command or data to be used by a component (e.g., the processor 620) of the electronic device 601, from the outside (e.g., a user) of the electronic device 601. The input device 650 may include, for example, a microphone, a mouse, a keyboard, or a digital pen (e.g., a stylus pen).

The sound output device 655 may output sound signals to the outside of the electronic device 601. The sound output device 655 may include, for example, a speaker or a receiver. The speaker may be used for general purposes, such as playing multimedia or playing record, and the receiver may be used for incoming calls. According to an embodiment, the receiver may be implemented as separate from, or as part of the speaker.

The display device 660 may visually provide information to the outside (e.g., a user) of the electronic device 601. The display device 660 may include, for example, a display, a hologram device, or a projector and control circuitry to control a corresponding one of the display, hologram device, and projector. According to an embodiment, the display device 660 may include touch circuitry adapted to detect a touch, or sensor circuitry (e.g., a pressure sensor) adapted to measure the intensity of force incurred by the touch.

The audio module 670 may convert a sound into an electrical signal and vice versa. According to an embodiment, the audio module 670 may obtain the sound via the input device 650, or output the sound via the sound output device 655 or an external electronic device (e.g., an electronic device 602 (e.g., a speaker or a headphone)) directly or wirelessly coupled with the electronic device 601.

The sensor module 676 may detect an operational state (e.g., power or temperature) of the electronic device 601 or an environmental state (e.g., a state of a user) external to the electronic device 601, and then generate an electrical signal or data value corresponding to the detected state. According to an embodiment, the sensor module 676 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 677 may support one or more specified protocols to be used for the electronic device 601 to be coupled with the external electronic device (e.g., the electronic device 602) directly or wirelessly. According to an embodiment, the interface 677 may include, for example, a high definition multimedia interface (HDMI), a universal serial bus (USB) interface, a secure digital (SD) card interface, or an audio interface.

A connecting terminal 678 may include a connector via which the electronic device 601 may be physically connected with the external electronic device (e.g., the electronic device 602). According to an embodiment, the connecting terminal 678 may include, for example, an HDMI connector, a USB connector, an SD card connector, or an audio connector (e.g., a headphone connector).

The haptic module 679 may convert an electrical signal into a mechanical stimulus (e.g., a vibration or a movement) or electrical stimulus which may be recognized by a user via his tactile sensation or kinesthetic sensation. According to an embodiment, the haptic module 679 may include, for example, a motor, a piezoelectric element, or an electric stimulator.

The camera module 680 may capture a still image and moving images. According to an embodiment, the camera module 680 may include one or more lenses, image sensors, image signal processors, or flashes.

The power management module 688 may manage power supplied to the electronic device 601. According to one embodiment, the power management module 688 may be implemented as at least part of, for example, a power management integrated circuit (PMIC).

The battery 689 may supply power to at least one component of the electronic device 601. According to an embodiment, the battery 689 may include, for example, a primary cell which is not rechargeable, a secondary cell which is rechargeable, or a fuel cell.

The communication module 690 may support establishing a direct (e.g., wired) communication channel or a wireless communication channel between the electronic device 601 and the external electronic device (e.g., the electronic device 602, the electronic device 604, or the server 608) and performing communication via the established communication channel. The communication module 690 may include one or more communication processors that are operable independently from the processor 620 (e.g., the application processor (AP)) and support a direct (e.g., wired) communication or a wireless communication. According to an embodiment, the communication module 690 may include a wireless communication module 692 (e.g., a cellular communication module, a short-range wireless communication module, or a global navigation satellite system (GNSS) communication module) or a wired communication module 694 (e.g., a local area network (LAN) communication module or a power line communication (PLC) module). A corresponding one of these communication modules may communicate with the external electronic device via the first network 698 (e.g., a short-range communication network, such as BluetoothTM, wireless-fidelity (Wi-Fi) direct, or infrared data association (IrDA)) or the second network 699 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 692 may identify and authenticate the electronic device 601 in a communication network, such as the first network 698 or the second network 699, using subscriber information (e.g., international mobile subscriber identity (IMSI)) stored in the subscriber identification module 696.

The antenna module 697 may transmit or receive a signal or power to or from the outside (e.g., the external electronic device) of the electronic device 601. According to an embodiment, the antenna module may include an antenna including a radiating element composed of a conductive material or a conductive pattern formed in or on a substrate (e.g., PCB). According to an embodiment, the antenna module 697 may include a plurality of antennas. In such a case, at least one antenna appropriate for a communication scheme used in the communication network, such as the first network 698 or the second network 699, may be selected, for example, by the communication module 690 from the plurality of antennas. The signal or the power may then be transmitted or received between the communication module 690 and the external electronic device via the selected at least one antenna. According to an embodiment, another component (e.g., a radio frequency integrated circuit (RFIC)) other than the radiating element may be additionally formed as part of the antenna module 697.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 601 and the external electronic device 604 via the server 608 coupled with the second network 699. Each of the electronic devices 602 and 604 may be a device of a same type as, or a different type, from the electronic device 601. According to an embodiment, all or some of operations to be executed at the electronic device 601 may be executed at one or more of the external electronic devices 602, 604, or 608. For example, if the electronic device 601 should perform a function or a service automatically, or in response to a request from a user or another device, the electronic device 601, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 601. The electronic device 601 may provide the outcome, with or without further processing of the outcome, as at least part of a reply to the request. To that end, a cloud computing, distributed computing, or client-server computing technology may be used, for example.

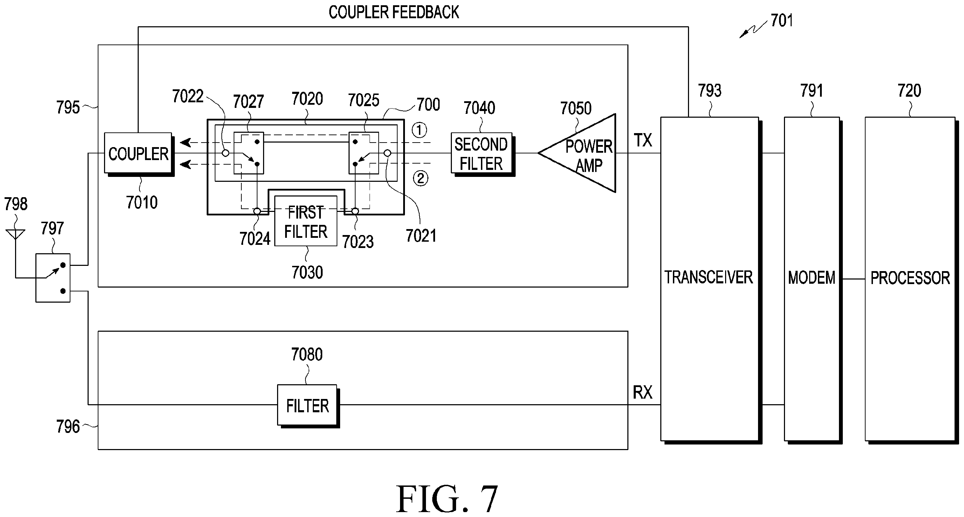

FIG. 7 is a diagram illustrating an electronic device including a switch on a transmission circuit according to an embodiment.

Referring to FIG. 7, the electronic device 701 (e.g., the electronic device 601 of FIG. 6) may include a processor 720, a modem 791, a transceiver 793, a transmission circuit 795, a reception circuit 796, an antenna switch 797, or an antenna 798.

According to an embodiment, the processor 720 may control at least one other component (e.g., a hardware or software component) of the electronic device 701, and may perform various data processing or operations. According to an embodiment, the processor 720 may include at least one processor, for example, an application processor (AP) and/or a communication processor (CP). The processor 720 may perform processing or operation of communication data during communication using the modem 791, the transceiver 793, the transmission circuit 795, the reception circuit 796, the antenna switch 797, and/or the antenna 798, and may control the operation of the switch 700 on the transmission circuit.

According to an embodiment, the modem 791 may modulate and output transmission target data into a digital signal, or may acquire received data by demodulating the received digital signal. The transceiver 793 according to an embodiment may convert the transmission target digital signal output by the modem 791 into an analog transmission signal (TX) (RF signal) of the transmission band and output the same to the transmission circuit 795, or may convert the analog signal RX (RF signal) of the reception band received through the reception circuit 796 into a digital signal and output the converted signal to the modem 791.

According to an embodiment, the transmission circuit 795 may include a coupler 7010, a switch 700, a first filter 7030, a second filter 7040, or a power amplifier 7050. The transmission circuit 795 may perform transmission signal processing including, for example, amplification, filtering, or/and coupling operations of the transmission signal between the antenna switch 797 (or antenna 798) and the transceiver 793. The coupler 7010 may extract a portion of a transmission signal and feed it back to the transceiver 793, and the transceiver 793 may perform transmission signal processing based on the coupler feedback.

According to an embodiment, the reception circuit 796 may include a filter 7080 , or an amplifier (not shown), and may perform reception signal processing including amplifying and/or filtering of the reception signal between the antenna switch 797 (or the antenna 798) and the transceiver 793.

According to an embodiment, the switch 700 of the transmission circuit 795 may include a circuit 7020 including a first terminal 7021, a second terminal 7022, a third terminal 7023, a fourth terminal 7024, a first switch element 7025, or a second switch element 7027, the first terminal 7021 may be connected to the second filter 7040, and the second terminal 7022 may be connected to the coupler 7010 2 7040. According to an embodiment, at least one of the first switch element 7025 and the second switch element 7027 may be replaced with a branch circuit.

The first switch element 7025 (e.g., the second switch element 472 of FIG. 4A) or the second switch element 7025 (e.g., the first switch element 471 of FIG. 4A) may be controlled based on the control signal from the processor 720 to form a first path ① that bypasses the signal input from the second filter 7040 through the inside of the switch 700 and transfers it to the coupler 7010 and a second path ② for transferring the signal input from the second filter 7040 to the coupler 7010 through the first filter 7030 outside the switch 700.

According to an embodiment, the first filter 7030 may be an interference signal (e.g., a signal of a reception band) cancellation filter (e.g., a notch filter). In an embodiment, the second filter 7040 may be a transmission band-pass filter (e.g., a band-pass filter).

According to an embodiment, when no interference signal exists (e.g., when a signal (e.g., b66) of a reception frequency band adjacent to a transmission frequency band (e.g., n41) is not received) during transmission, the processor 720 may control the first switch element 7025 and/or the second switch element 7027 to form the first path (1).

According to an embodiment, when an interfering signal is present (e.g., when a signal in the receiving frequency band adjacent to the transmitting frequency band is received) during transmission, the processor 720 may control the first switch element 7025 and/or the second switch element 7027 to form the second path (2) so that an interference signal (e.g., a signal in a reception frequency band adjacent to a transmission frequency band) may be removed by the first filter 7030.

According to an embodiment, the first filter 7030 may be an external device of the switch 700. For example, the first filter 7030 may be a type of external device of the switch 700 and may be replaced with an external device other than the first filter 7030. For example, the transmission circuit 795 may include an amplifier or an attenuator instead of the first filter 7030 (e.g., a filter). As another example, the transmission circuit 795 may include at least one of a first filter 7030 (e.g., a filter), an amplifier, and an attenuator.

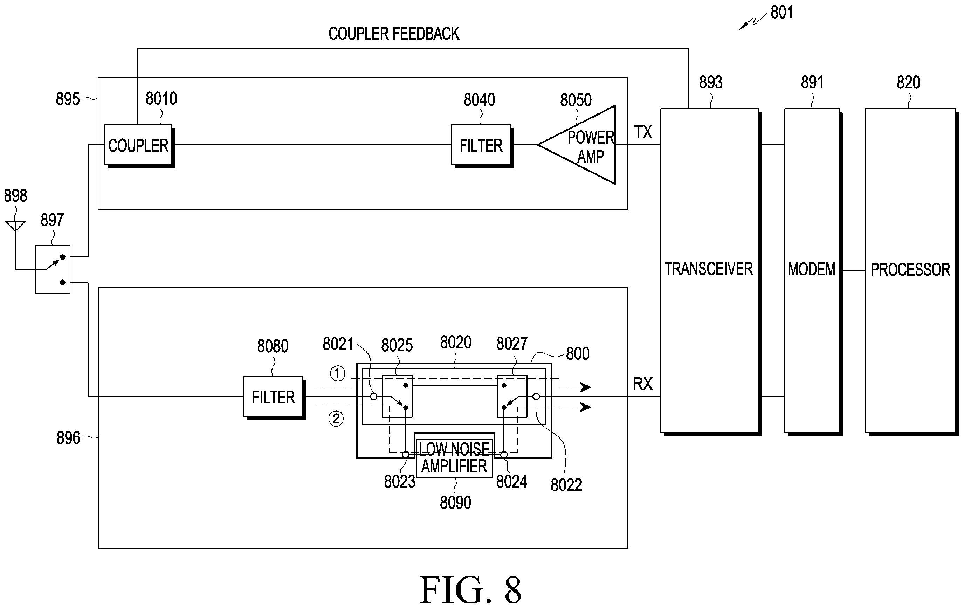

FIG. 8 is a diagram illustrating an electronic device including a switch on a reception circuit according to an embodiment.

Referring to FIG. 8, the electronic device 801 (e.g., the electronic device 601 of FIG. 6) may include a processor 820, a modem 891, a transceiver 893, a transmission circuit 895, a reception circuit 896, an antenna switch 897, or an antenna 898.

According to an embodiment, the processor 820 may control at least one other component (e.g., a hardware or software component) of the electronic device 801, and may perform various data processing or operations. According to an embodiment, the processor 820 may include at least one processor, for example, an application processor (AP) and/or a communication processor (CP). The processor 820 may perform processing or operation of communication data during communication using the modem 891, the transceiver 893, the transmission circuit 895, the reception circuit 896, the antenna switch 897, and/or the antenna 898, and may control the operation of the switch 800 on the transmission circuit.

According to an embodiment, the modem 891 may modulate and output transmission target data into a digital signal, or may acquire received data by demodulating the received digital signal. The transceiver 893 according to an embodiment may convert the transmission target digital signal output by the modem 791 into an analog transmission signal (TX) (RF signal) of the transmission band and output the same to the transmission circuit 895, or may convert the analog signal RX (RF signal) of the reception band received through the reception circuit 896 into a digital signal and output the converted signal to the modem 891.

According to an embodiment, the transmission circuit 895 may include a coupler 8010, a filter 8040, or a power amplifier 8050, and may perform transmission signal processing including amplification, filtering, or/and coupling operations of the transmission signal between the antenna switch 897 (or antenna 898) and the transceiver 893. The coupler 8010 may extract a portion of a transmission signal and feed it back to the transceiver 893, and the transceiver 893 may perform transmission signal processing based on the coupler feedback.

According to an embodiment, the reception circuit 896 may include a filter 8080 , a switch 800, or a low noise amplifier 8090, and may perform reception signal processing including amplifying and/or filtering of the reception signal between the antenna switch 897 (or the antenna 898) and the transceiver 893.

According to an embodiment, the switch 800 of the reception circuit 896 may include a circuit 8020 including a first terminal 8021, a second terminal 8022, a third terminal 8023, a fourth terminal 8024, a first switch element 8025, or a second switch element 8027, the first terminal 8021 may be connected to the filter 8080, and the second terminal 8022 may be connected to the transceiver 893. According to an embodiment, at least one of the first switch element 8025 and the second switch element 8027 may be replaced with a branch circuit. According to an embodiment, the first switch element 8025 and the second switch element 8027 may be controlled based on the control signal from the processor 820 to form a first path ① that bypasses the signal input from the filter 8080 through the inside of the switch 800 and transfers it to the transceiver 893 and a second path ② for transferring the signal input from the filter 8080 to the transceiver 893 through the low-noise amplifier 8090 outside the switch 800.

According to an embodiment, the filter 8080 may be a transmission band-pass filter (e.g., a band-pass filter). According to an embodiment, the low noise amplifier 8090 may be an amplifier that amplifies low noise in a received signal.

According to an embodiment, when the strength of the signal received through the antenna 898 is not weak (e.g., greater than the specified strength) during reception, the processor 820 may control the first switch element 8025 and/or the second switch element 8027 to form the first path (1).

According to an embodiment, when the strength of the signal received through the antenna 898 is weak (e.g., less than the specified strength) during reception, the processor 820 may control the first switch element 8025 and/or the second switch element 8027 to form the second path ② so that the received signal is amplified.

According to an embodiment, the low noise amplifier 8090 may be an external device of the switch 800. For example, the low noise amplifier 8090 may be a type of external device of the switch 800 and may be replaced with an external device other than the low noise amplifier 8090. For example, the receiving circuit 896 may include a filter or an attenuator instead of the low noise amplifier 8090 (e.g., an amplifier).

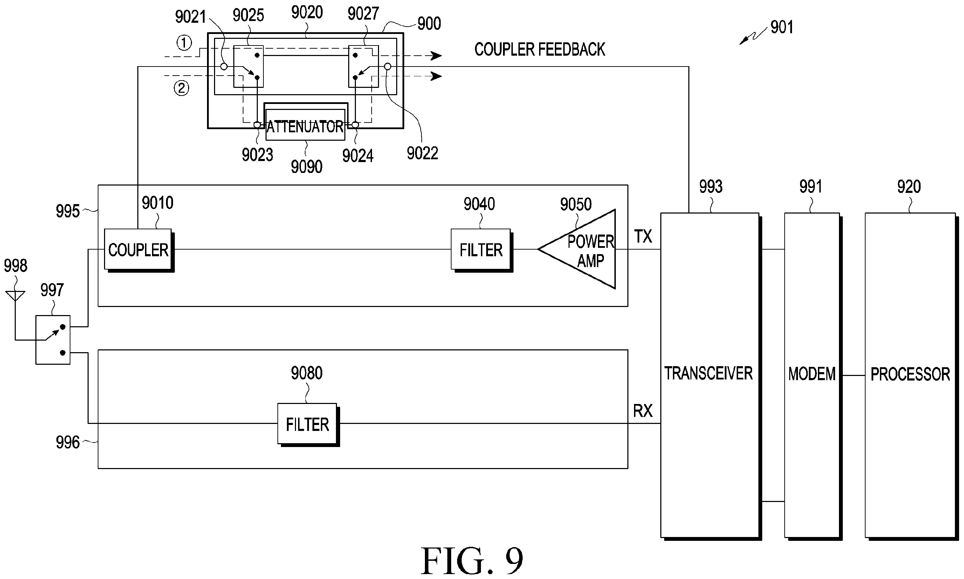

FIG. 9 is a diagram illustrating an electronic device including a switch on a coupler feedback path according to an embodiment.

Referring to FIG. 9, the electronic device 901 (e.g., the electronic device 601 of FIG. 6) may include a processor 920, a modem 991, a transceiver 993, a transmission circuit 995, a reception circuit 996, an antenna switch 997, an antenna 998, switch 900, or an attenuator 9090.

According to an embodiment, the processor 920 may control at least one other component (e.g., a hardware or software component) of the electronic device 901, and may perform various data processing or operations. According to an embodiment, the processor 920 may include at least one processor, for example, an application processor (AP) and/or a communication processor (CP). The processor 920 may perform processing or operation of communication data during communication using the modem 991, the transceiver 993, the transmission circuit 995, the reception circuit 996, the antenna switch 997, and/or the antenna 998, and may control the operation of the switch 900 on the coupler feedback path.

According to an embodiment, the modem 991 may modulate and output transmission target data into a digital signal, or may acquire received data by demodulating the received digital signal. The transceiver 993 according to an embodiment may convert the transmission target digital signal output by the modem 991 into an analog transmission signal (TX) (RF signal) of the transmission band and output the same to the transmission circuit 995, or may convert the analog signal RX (RF signal) of the reception band received through the reception circuit 996 into a digital signal and output the converted signal to the modem 991.

According to an embodiment, the transmission circuit 995 may include a coupler 9010, a filter 9040, or a power amplifier 9050, and may perform transmission signal processing including amplification, filtering, or/and coupling operations of the transmission signal between the antenna switch 997 (or antenna 998) and the transceiver 993. The coupler 9010 may extract a portion of a transmission signal and feed it back to the transceiver 993, and the transceiver 993 may perform transmission signal processing based on the coupler feedback.

According to an embodiment, the reception circuit 996 may include a filter 9080 or/and an amplifier (not shown), and may perform reception signal processing including amplifying and/or filtering of the reception signal between the antenna switch 997 (or the antenna 998) and the transceiver 993.

According to an embodiment, a switch 9020 and an attenuator 9024 may be disposed on the coupler feedback path. In an embodiment, the switch 900 may include a circuit 9020 including a first terminal 9021, a second terminal 9022, a third terminal 9023, a fourth terminal 9024, a first switch element 9025, or a second switch element 9027, the first terminal 9021 may be connected to the coupler 9020, and the second terminal 9022 may be connected to the transceiver 993. According to an embodiment, at least one of the first switch element 925 and the second switch element 927 may be replaced with a branch circuit. According to an embodiment, the first switch element 8025 or the second switch element 8027 may be controlled based on the control signal from the processor 920 to form a first path ① that bypasses the signal input from the coupler 9010 through the inside of the switch 900 and transfers the same to the transceiver 993 and a second path ② for transferring the signal input from the coupler 9010 to the transceiver 993 through the attenuator 9090 outside the switch 800. According to an embodiment, the attenuator 9090 may attenuate the signal to be included in the specified power when the power of the signal input from the coupler 9010 is equal to or greater than the specified power.

According to an embodiment, when the power range of the coupler feedback signal input from the coupler 9010 to the transceiver 993 is within the specified range, the processor 920 may control the first switch element 9025 and/or the second switch element 9027 to form the first path (1).

According to an embodiment, when the power range of the coupler feedback signal input from the coupler 9010 to the transceiver 993 is exceeded, the processor 920 may control the first switch element 9025 and/or the second switch element 9027 to form the second path ② to attenuate the strength of the coupler feedback signal.

According to an embodiment, the attenuator 9024 may be an external device to the switch 900. For example, the attenuator 9024 may be one type of external device of the switch 900, and the attenuator 9024 may be replaced with another type of external device. For example, the coupler feedback path may include a filter or an amplifier instead of the attenuator 9024.

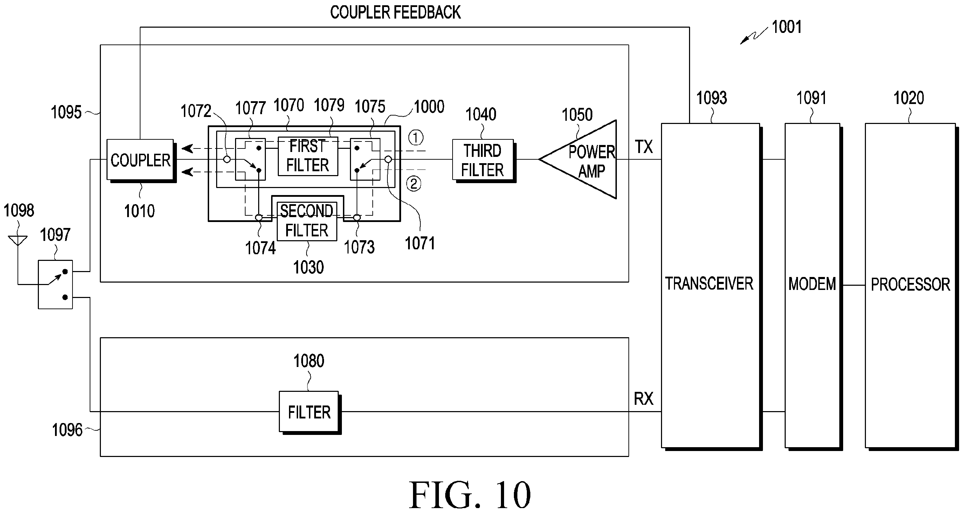

FIG. 10 is a diagram illustrating an electronic device including a switch having a filter on a transmission circuit according to an embodiment.

Referring to FIG. 10, the electronic device 1001 (e.g., the electronic device 601 of FIG. 6) may include a processor 1020, a modem 1091, a transceiver 1093, a transmission circuit 1095, a reception circuit 1096, an antenna switch 1097, or an antenna 1098, or a switch 1000.

According to an embodiment, the processor 1020 may control at least one other component (e.g., a hardware or software component) of the electronic device 1001, and may perform various data processing or operations. According to an embodiment, the processor 1020 may include at least one processor, for example, an application processor (AP) and/or a communication processor (CP). The processor 1020 may perform processing or operation of communication data during communication using the modem 1091, the transceiver 1093, the transmission circuit 1095, the reception circuit 1096, the antenna switch 1097, and/or the antenna 1098, and may control the operation of the switch 1000 on the transmission circuit.

According to an embodiment, the modem 1091 may modulate and output transmission target data into a digital signal, or may acquire received data by demodulating the received digital signal. The transceiver 1093 according to an embodiment may convert the transmission target digital signal output by the modem 1091 into an analog transmission signal (TX) (RF signal) of the transmission band and output the same to the transmission circuit 1095, or may convert the analog signal RX (RF signal) of the reception band received through the reception circuit 1096 into a digital signal and output the converted signal to the modem 1091.

According to an embodiment, the transmission circuit 1095 may include a coupler 1010, a switch 1070, a second filter 1030, a third filter 1040, or a power amplifier 1050. The transmission circuit 1095 may perform transmission signal processing including amplification, filtering, or/and coupling operations of the transmission signal between the antenna switch 1097 (or antenna 1098) and the transceiver 1093. The coupler 1010 may extract a portion of a transmission signal and feed the same back to the transceiver 1093, and the transceiver 1093 may perform transmission signal processing based on the coupler feedback.

According to an embodiment, the reception circuit 1096 may include a filter 1080 or an amplifier (not shown), and may perform reception signal processing including amplifying and/or filtering of the reception signal between the antenna switch 1097 (or the antenna 1098) and the transceiver 1093.

According to an embodiment, the switch 1000 of the transmission circuit 1095 may include a first terminal 1071, a second terminal 1072, a third terminal 1073, a fourth terminal 1074, a first switch element 1075, a second switch element 1077, or a filter 1079, and the first terminal 1071 may be connected to a third filter 1040, and the second terminal 1072 may be connected to a coupler 1010. According to an embodiment, at least one of the first switch element 1075 and the second switch element 1077 may be replaced with a branch circuit. Based on a control signal (e.g., a first control signal) from the processor 1020, the first switch element 1075 or the second switch element 1077 may be controlled to form a first path ① for passing the transmission signal input from the third filter 1040 to the coupler 1010 through the inside of the switch 1000 by passing the first filter 1079 and a second path ② for transferring the transmission signal input from the third filter 1040 to the coupler 1010 through the second filter 1030 outside the switch 1000.

According to an embodiment, the first filter 1079 may be a first interference signal (e.g., a signal of a WLAN reception band) cancellation filter (e.g., a first notch filter). As another example, the second filter 1030 may be a second interference signal (e.g., a signal of the B66 reception band) cancellation filter (e.g., a second notch filter). As another example, the third filter 1040 may be a transmission band-pass filter (e.g., a transmission band-pass filter).

According to an embodiment, when the first interference signal is present (e.g., when a signal of a reception frequency band (e.g., WLAN reception band) adjacent to the transmission frequency band (e.g., n41) is received) during transmission, the processor 1020 may control the first switch element 1075 and/or the second switch element 1077 to form the first path ① so that the first interference signal is removed by the first filter 1079. For example, the processor 1020 may control the first switch element 1075 so that the first terminal 1071 is electrically connected to the first filter 1079, and may control the second switch element 1077 such that the second terminal 1072 is electrically connected to the first filter 1079.

According to an embodiment, when a second interference signal is present (e.g., when a signal in a receiving frequency band (e.g., B66) adjacent to the transmission frequency band (e.g., n41) is received) during transmission, the processor 1020 may control the first switch element 1075 and/or the second switch element 1077 to form the second path ② so that the second interference signal is removed by the second filter 1030. For example, the processor 1020 controls the first switch element 1075 such that the first terminal 1071 is electrically connected to the third terminal 1073, and may control the second switch element 1077 such that the second terminal 1072 is electrically connected to the fourth filter 1074.

According to an embodiment, the first filter 1079 may be an RF signal processing element inside the switch 1000, and the second filter 1030 may be an external device of the switch 1000. For example, the first filter 1079 may be one type of RF signal processing element inside the switch 1000, and may be replaced with another type of RF signal processing element. For example, an attenuator or an amplifier may be included instead of the first filter 1079. As another example, the switch 1000 may include at least one of a first filter 1079, an attenuator, or an amplifier. For example, the second filter 1030 may be a type of external device of the switch 1000, and the second filter 1030 may be replaced with another type of external device. For example, an attenuator or an amplifier may be included instead of the second filter 1030. As another example, at least one of the second filter 1030, an attenuator, and an amplifier may be included.

According to various embodiments, the electronic device (e.g., the electronic device 601 of FIG. 6, the electronic device 701 of FIG. 7, the electronic device 801 of FIG. 8, the electronic device 901 of FIG. 9, or the electronic device 1001 of FIG. 10) may include an antenna (e.g., the antenna module 697 of FIG. 6, the antenna 798 of FIG. 7, the antenna 898 of FIG. 8, the antenna 998 of FIG. 9, or the antenna 1098 of FIG. 10), a transceiver (e.g., the communication module 697 of FIG. 6, the transceiver 793 of FIG. 7, the transceiver 893 of FIG. 8, the transceiver 993 of FIG. 9, or the transceiver 1093 of FIG. 10), and the switch (e.g., the switch 700 of FIG. 7, the switch 800 of FIG. 8, the switch 900 of FIG. 9, or the switch 1000 of FIG. 10) connected between the antenna and the transceiver, the switch may include a first terminal (e.g., the first terminal 7021 of FIG. 7, the first terminal 8021 of FIG. 8, the first terminal 9021 of FIG. 9, or the first terminal 1071 of FIG. 10) for receiving an RF signal from the transceiver, a second terminal (e.g., the second terminal 7022 of FIG. 7, the second terminal 8022 of FIG. 8, the second terminal 9022 of FIG. 9, or the second terminal 1072 of FIG. 10) electrically connectable to the first terminal, a third terminal (e.g., the third terminal 7023 of FIG. 7, the third terminal 8023 of FIG. 8, the third terminal 9023 of FIG. 9, or the third terminal 1073 of FIG. 10) electrically connectable to the first terminal, a fourth terminal (e.g., the fourth terminal 7024 of FIG. 7, the fourth terminal 8024 of FIG. 8, the fourth terminal 9024 of FIG. 9, or the fourth terminal 1074 of FIG. 10) electrically connectable to the second terminal, and a circuit (e.g., the circuit 7020 of FIG. 7, the circuit 8020 of FIG. 8, the circuit 9020 of FIG. 9, or the circuit 1070 of FIG. 10) electrically connected to the first terminal, the second terminal, the third terminal, and the fourth terminal, the circuit may form a first path through which the RF input signal is transmitted by electrically connecting the first terminal and the second terminal based on a first control signal, and may connect the first terminal and the third terminal based on a second control signal, and connect the second terminal and the fourth terminal to form a second path through which the RF input signal is transmitted.

According to an embodiment, the circuit may include a first switch element (e.g., the first switch element 7025 of FIG. 7, the first switch element 8025 of FIG. 8, the first switch element 9025 of FIG. 9, or the first switch element 1025 of FIG. 10) electrically connected to the first terminal and the third terminal, and a second switch element (e.g., the second switch element 7027 of FIG. 7, the second switch element 8027 of FIG. 8, the second switch element 9027 of FIG. 9, or the second switch element 1027 of FIG. 10) connected to the first terminal through a conductive line L and electrically connected to the second terminal and the fourth terminal, the first switch element may connect the first terminal and the conductive line and the second switch element may connect the conductive line and the second terminal, based on the first control signal to form the first path through the inside of the switch, and the first switch element may connect the first terminal and the third terminal and the second switch element may connect the second terminal and the fourth terminal, based on the second control signal to form the second path through the outside of the switch.

According to an embodiment, the circuit may include a switch element electrically connected to the first terminal and the third terminal, and a branch circuit electrically connected to the switch element through a conductive line and electrically connected to the second terminal and the fourth terminal, the switch element may connect the first terminal and the conductive line and the branch circuit may connect the conductive line and the second terminal, based on the first control signal to the first path through the inside of the switch, and the switch element may connect the first terminal and the third terminal and the branch circuit may connect the second terminal and the fourth terminal, based on the second control signal to form the second path through the outside of the switch.

According to an embodiment, the circuit may include a branch circuit electrically connected to the first terminal and the third terminal, and a switch element connected to the branch circuit through a conductive line and electrically connected to the second terminal and the fourth terminal, the switch element may connect the first terminal and the conductive line and the branch circuit may connect the conductive line and the second terminal, based on the first control signal to form the first path through the inside of the switch, and the branch circuit may connect the first terminal and the third terminal and the switch element may connect the second terminal and the fourth terminal, based on the second control signal to form the second path through the outside of the switch.

According to an embodiment, the circuit may include a first branch circuit electrically connected to the first terminal and the third terminal, and a second branch circuit connected to the first branch circuit through a conductive line and electrically connected to the second terminal and the fourth terminal, the first branch circuit element may connect the first terminal and the conductive line and the second branch circuit may connect the conductive line and the second terminal, based on the first control signal to form the first path through the inside of the switch, and the first branch circuit may connect the first terminal and the third terminal and the second branch circuit may connect the second terminal and the fourth terminal, based on the second control signal to form the second path through the outside of the switch.

According to an embodiment, an external device may be connected between the third terminal and the fourth terminal.

According to an embodiment, an RF processing element connected between the first switch and the second switch may be included.

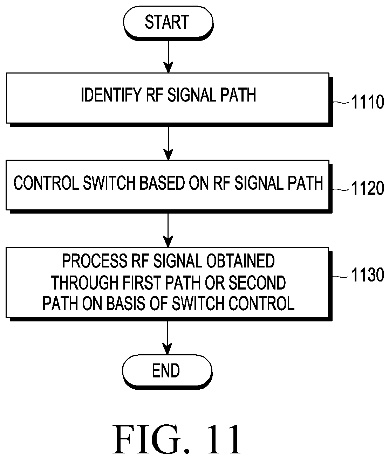

According to an embodiment, the RF processing element or the external device may include at least one of a filter, an attenuator, and an amplifier. FIG. 11 is a flowchart illustrating a method for controlling a switch in an electronic device according to an embodiment.

Referring to FIG. 11, a processor (e.g., the processor 620 of FIG. 6, the processor 720 of FIG. 7, the processor 820 of FIG. 8, the processor 920 of FIG. 9, or the processor 1020 of FIG. 10) of the electronic device (e.g., the electronic device 601 of FIG. 6, the electronic device 701 of FIG. 7, the electronic device 801 of FIG. 8, the electronic device 901 of FIG. 9, or the electronic device 1001 of FIG. 10) according to an embodiment may perform some or all of the operations 1110 to 1130.

In operation 1110, the processor 610 according to an embodiment may identify an RF signal path. According to an embodiment, the processor 610 may identify the RF signal path on a transmission circuit (e.g., the transmission circuit 795 of FIG. 7) or a reception circuit (e.g., the reception circuit 796 of FIG. 7) between an antenna (e.g., the antenna 798 of FIG. 7) and a transceiver (e.g., the transceiver 793 of FIG. 7). For example, the processor 610 may identify whether the RF signal is a first path through which the RF signal is bypassed (e.g., the first path (1) in FIG. 7) or whether the RF signal is a second path (e.g., the second path ② of FIG. 7) requiring RF signal processing (e.g., filtering, attenuation, amplification).

In operation 1120, the processor 610 according to an embodiment may control a switch (e.g., the switch 7020 of FIG. 7) that receives the RF input signal based on the confirmation of the RF signal path. For example, the processor 610 may control at least one switch element (e.g., the first switch element 7025 or the second switch element 7027 of FIG. 7) included in the switch for receiving the RF signal input signal or at least one branch circuit (e.g., the branch circuit 74 of FIG. 2B) so that the switch may form a first path through which the RF input signal is bypassed or a second path through which the RF input signal is processed (e.g., filtered, attenuated, amplified).

In operation 1130, the processor 610 according to an embodiment may control a device (or circuit) that processes the RF output signal output through the first path or the second path based on the switch control. For example, the processor 610 may control a second external element (or circuit) (e.g., the second filter 7040 of FIG. 7) to process a first RF output signal that is bypassed to a first path from a first external element (or circuit) (e.g., coupler 7010 in FIG. 7) through a switch, or may control the second external element (or circuit) (e.g., the second filter 7040 of FIG. 7) to process a second RF output signal output by RF signal processing from the first external element (or circuit) (e.g., the coupler 7010 of FIG. 7) to the second path through the switch. For example, RF signal processing may include filtering, attenuation, or/and amplification processing.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., a program 640) including one or more instructions that are stored in a storage medium (e.g., internal memory 636 or external memory 638) that is readable by a machine (e.g., the electronic device 601). For example, a processor (e.g., the processor 620) of the machine (e.g., the electronic device 601) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to various embodiments, in a storage medium storing instructions, the instructions may be configured to cause the at least one processor to perform at least one operation when executed by the at least one processor, the at least one operation may include identifying an RF signal path on the transmission circuit or the reception circuit between the antenna and the transceiver, controlling the switch for receiving the RF input signal based on the RF signal path check so that the switch forms a first path through which the RF input signal is bypassed or a second path through which the RF input signal is processed with an RF signal, and controlling the RF output signal output through the first path or the second path to be processed based on the switch control.

The embodiments of the present disclosure disclosed in the present specification and drawings are merely presented as specific examples to easily explain the technical contents according to the embodiments of the present disclosure and help the understanding of the embodiments of the present disclosure, and it is not intended to limit the scope of the embodiments. Therefore, in the scope of various embodiments of the present disclosure, in addition to the embodiments disclosed herein, all changes or modifications derived from the technical ideas of various embodiments of the present disclosure should be interpreted as being included in the scope of various embodiments of the present disclosure.

## Claims

1. A switch comprising:
a first terminal for receiving an RF input signal;
a second terminal electrically connectable to the first terminal;
a third terminal electrically connectable to the first terminal;
a fourth terminal electrically connectable to the second terminal; and
a circuit for electrically connecting the first terminal and the second terminal, based on a first control signal to form a first path through which the RF input is transmitted, and for connecting the first terminal and the third terminal and connecting the second terminal and the fourth terminal, based on a second control signal to form a second path through which the RF input signal is transmitted.

2. The switch of claim 1, wherein the circuit comprises:
a first switch element electrically connected to the first terminal and the third terminal; and
a second switch element connected to the first switch through a conductive line and electrically connected to the second terminal and the fourth terminal,
wherein, based on the first control signal, the first switch element connects the first terminal and the conductive line, and the second switch element connects the conductive line and the second terminal to form the first path through the inside of the switch, and
wherein, based on the second control signal, the first switch element connects the first terminal and the third terminal, and the second switch element connects the second terminal and the fourth terminal to form the second path through the outside of the switch.

3. The switch of claim 1, wherein the circuit comprises:
a switch element electrically connected to the first terminal and the third terminal; and
a branch circuit electrically connected to the switch element through a conductive line and electrically connected to the second terminal and the fourth terminal,
wherein, based on the first control signal, the switch element connects the first terminal and the conductive line, and the branch circuit connects the conductive line and the second terminal to form the first path through the inside of the switch, and
wherein, based on the second control signal, the switch element connects the first terminal and the third terminal, and the branch circuit connects the second terminal and the fourth terminal to form the second path through the outside of the switch.

4. The switch of claim 1, wherein the circuit comprises:
a branch circuit electrically connected to the first terminal and the third terminal; and
a switch element connected to the branch circuit through a conductive line and electrically connected to the second terminal and the fourth terminal,
wherein, based on the first control signal, the switch element connects the first terminal and the conductive line, and the branch circuit connects the conductive line and the second terminal to form the first path through the inside of the switch, and
wherein, based on the second control signal, the branch circuit connects the first terminal and the third terminal, and the switch element connects the second terminal and the fourth terminal to form the second path through the outside of the switch.

5. The switch of claim 1, wherein the circuit comprises:
a first branch circuit electrically connected to the first terminal and the third terminal; and
a second branch circuit connected to the first branch circuit through a conductive line and electrically connected to the second terminal and the fourth terminal,
wherein, based on the first control signal, the first branch circuit element connects the first terminal and the conductive line, and the second branch circuit connects the conductive line and the second terminal to form the first path through the inside of the switch, and
wherein, based on the second control signal, the first branch circuit connects the first terminal and the third terminal, and the second branch circuit connects the second terminal and the fourth terminal to form the second path through the outside of the switch.

6. The switch of claim 1, wherein an external device is connected between the third terminal and the fourth terminal.

7. The switch of claim 2, comprising an RF signal processing element connected between the first switch element and the second switch element.

8. The switch of claim 7, wherein the RF processing element or the external device comprises at least one of a filter, an attenuator, or an amplifier.

9. A switch comprising:
a first terminal for receiving an RF input signal;
a second terminal electrically connectable to the first terminal;
a third terminal electrically connectable to the first terminal;
a fourth terminal electrically connectable to the second terminal;
a first switch for connecting or disconnecting the first terminal and the third terminal; and
a circuit comprising a second switch electrically connected to the first switch through a conductive line and configured to connect or disconnect the second terminal and the fourth terminal,
wherein an external device is connected between the third terminal and the fourth terminal,
wherein, based on a first control signal, the first switch connects the first terminal and the conductive line, and the second switch electrically connects the conductive line and the second terminal to form a first path through which the RF input signal is transmitted through the inside of the switch, and
wherein, based on a second control signal, the first switch connects the first terminal and the third terminal, and the second switch connects the second terminal and the fourth terminal to form a second path through which the RF input signal is transmitted through the outside of the switch.

10. The switch of claim 9, comprising an RF signal processing element connected between the first switch and the second switch,
wherein the RF signal processing element or the external device comprises at least one of a filter, an attenuator, or an amplifier.

11. An electronic device comprising:
an antenna;
a transceiver; and
a switch connected between the antenna and the transceiver,
wherein the switch comprises:
a first terminal for receiving an RF input signal from the transceiver;
a second terminal electrically connectable to the first terminal;
a third terminal electrically connectable to the first terminal;
a fourth terminal electrically connectable to the second terminal; and
a circuit electrically connected to the first terminal, the second terminal, the third terminal and the fourth terminal, and
wherein, based on a first control signal, the circuit electrically connects the first terminal and the second terminal to form a first path through which the RF input signal is transmitted, and based on a second control signal, connects the first terminal and the third terminal and connects the second terminal and the fourth terminal to form a second path through which the RF input signal is transmitted.

12. The switch of claim 11, wherein the circuit comprises:
a first switch element electrically connected to the first terminal and the third terminal; and
a second switch element connected to the first switch through a conductive line and electrically connected to the second terminal and the fourth terminal,
wherein, based on the first control signal, the first switch element connects the first terminal and the conductive line, and the second switch element connects the conductive line and the second terminal to form the first path through the inside of the switch, and
wherein, based on the second control signal, the first switch element connects the first terminal and the third terminal, and the second switch element connects the second terminal and the fourth terminal to form the second path through the outside of the switch.

13. The switch of claim 11, wherein the circuit comprises:
a switch element electrically connected to the first terminal and the third terminal; and
a branch circuit electrically connected to the switch element through a conductive line and electrically connected to the second terminal and the fourth terminal,
wherein, based on the first control signal, the switch element connects the first terminal and the conductive line, and the branch circuit connects the conductive line and the second terminal to form the first path through the inside of the switch, and
wherein, based on the second control signal, the switch element connects the first terminal and the third terminal, and the branch circuit connects the second terminal and the fourth terminal to form the second path through the outside of the switch.

14. The switch of claim 11, wherein the circuit comprises:
a branch circuit electrically connected to the first terminal and the third terminal; and
a switch element connected to the branch circuit through a conductive line and electrically connected to the second terminal and the fourth terminal,
wherein, based on the first control signal, the switch element connects the first terminal and the conductive line, and the branch circuit connects the conductive line and the second terminal to form the first path through the inside of the switch, and
wherein, based on the second control signal, the branch circuit connects the first terminal and the third terminal, and the switch element connects the second terminal and the fourth terminal to form the second path through the outside of the switch.

15. The switch of claim 11, wherein the circuit comprises:
a first branch circuit electrically connected to the first terminal and the third terminal; and
a second branch circuit connected to the first branch circuit through a conductive line and electrically connected to the second terminal and the fourth terminal,
wherein, based on the first control signal, the first branch circuit element connects the first terminal and the conductive line, and the second branch circuit connects the conductive line and the second terminal to form the first path through the inside of the switch, and
wherein, based on the second control signal, the first branch circuit connects the first terminal and the third terminal, and the second branch circuit connects the second terminal and the fourth terminal to form the second path through the outside of the switch.
